(19) Europäisches Patentamt
European Patent Office
Office européen des brevets

(11) **EP 4 601 441 A1**

(12) **EUROPEAN PATENT APPLICATION**

(43) Date of publication:
**13.08.2025 Bulletin 2025/33**

(21) Application number: **24206980.5**

(22) Date of filing: **16.10.2024**

(51) International Patent Classification (IPC):
***H10K 59/122*** *(2023.01)* ***H10K 59/80*** *(2023.01)*

(52) Cooperative Patent Classification (CPC):
**H10K 59/878; H10K 59/122; H10K 59/80523;**
H10K 59/38; H10K 2102/3023

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **06.02.2024 KR 20240018330**

(71) Applicant: **LG Display Co., Ltd.**
**Seoul 07336 (KR)**

(72) Inventors:
• **Park, Hyemin**
**10845 Paju-si (KR)**

• **Kim, Donggu**
**10845 Paju-si (KR)**
• **Seong, Sejong**
**10845 Paju-si (KR)**
• **Choi, Inae**
**10845 Paju-si (KR)**
• **Kim, Taehyeon**
**10845 Paju-si (KR)**

(74) Representative: **Ter Meer Steinmeister & Partner**
**Patentanwälte mbB**
**Nymphenburger Straße 4**
**80335 München (DE)**

(54) **DISPLAY APPARATUS**

(57) A display apparatus comprising: a substrate including a plurality of pixels having a plurality of sub-pixels; a pattern portion disposed on the substrate to be concave in a non-light emission area between the plurality of the sub-pixels; and a reflective portion disposed on the pattern portion, wherein the pattern portion includes: a first inclined pattern portion disposed to have a first angle with respect to the upper surface of the substrate; and a second inclined pattern portion disposed between the first inclined pattern portion and the substrate and disposed to have a second angle with respect to an upper surface of the substrate.

FIG. 3

EP 4 601 441 A1

## Description

This application claims the benefit of the Korean Patent Applications No. 10-2024-0018330 filed on February 6, 2024.

## BACKGROUND

### Field of the Invention

The present disclosure relates to a display apparatus displaying images.

### Discussion of the Related Art

Since an organic light emitting display apparatus has a high response speed and low power consumption and self-emits light without requiring a separate light source unlike a liquid crystal display apparatus, there is no problem in a viewing angle and thus the organic light emitting display apparatus has received attention as a next-generation flat panel display apparatus.

Such a display apparatus displays an image through light emission of a light emitting element layer that includes a light emitting layer interposed between two electrodes.

Meanwhile, light extraction efficiency of the display apparatus is reduced as some of light emitted from the light emitting element layer is not emitted to the outside due to total reflection on the interface between multiple layers inside a display panel.

## SUMMARY

An object of the present disclosure is directed to providing a display apparatus in which a light extraction efficiency of light emitted from a light emitting element layer may be improved.

Further, an object of the present disclosure is directed to providing a display apparatus in which overall power consumption may be reduced through light extraction from a non-light emission area.

Further, an object of the present disclosure is directed to providing a display apparatus capable of maximizing light extraction efficiency.

The problems to be solved by the examples of the present disclosure are not limited to those mentioned above, and other problems not mentioned will be apparent to one of ordinary skill in the art to which the technical ideas of the present disclosure belong from the following description. At least one of the problems is solved by the features of the independent claim.

According to an aspect of the present disclosure, a display apparatus comprises: a substrate including a plurality of pixels having a plurality of sub-pixels; a pattern portion disposed on the substrate to be concave in a non-light emission area between the plurality of the sub-pixels; and a reflective portion disposed on the pattern portion, wherein the pattern portion includes: a first inclined pattern portion disposed to have a first angle with respect to the upper surface of the substrate; and a second inclined pattern portion disposed between the first inclined pattern portion and the substrate and disposed to have a second angle with respect to an upper surface of the substrate.

According to a further aspect of the present disclosure, a display apparatus comprises: a substrate including a plurality of sub-pixels; a pattern portion disposed on the substrate to be concave in a non-light emission area between the plurality of the sub-pixels; and a reflective portion disposed on the pattern portion. The pattern portion includes: a first inclined pattern portion disposed to have a first angle with respect to the substrate, in particular to an (upper) surface of the substrate; and a second inclined pattern portion disposed closer to the substrate and/or disposed between the first inclined pattern portion and the substrate and/or disposed to have a second angle with respect to the substrate, in particular to the (upper) surface of the substrate.

The display apparatus according to any one of these aspects may include one or more of the following features: "Concave" may describe recessed towards the substrate. That is, the pattern portion may be recessed towards the substrate. A "flat portion" may describe a planar portion, in particular a portion that is plane-parallel with the substrate.

The substrate may include a plurality of pixels having the plurality of sub-pixels. That is, the sub-pixels may be grouped into a plurality of pixels. For instance, three or four sub-pixels may form one pixel. The sub-pixels forming one pixel may have at least three different colors. One pixel may include, for instance, a red subpixel, a green subpixel and a blue subpixel; or a red sub-pixel, a white sub-pixel, a blue sub-pixel and a green sub-pixel. The sub-pixels forming one pixel may be arranged adjacent to each other, e.g. along one straight line.

The pattern portion may include a plurality of inclined pattern portions, including the first and the second inclined pattern portion. The pattern portion may be disposed within the non-light emission area, in particular the whole pattern portion may be disposed within the non-light emission area.

The pattern portion may include at least one flat pattern portion connecting two adjacent or neighboring or subsequent inclined pattern portions. The flat pattern portion may be plane-parallel with the substrate.

The reflective portion may have a shape corresponding to that of the pattern portion. That is, an upper surface (i.e. the surface facing away from the substrate) of the reflective portion may be plane-parallel to that of the pattern portion. The reflective portion may also include a plurality of inclined reflective portions respectively corresponding to one of the inclined pattern portions. The reflective portion may have a uniform thickness, e.g. when measured perpendicular to a surface of an underlying layer or structure. The reflective portion may cover the pattern portion. The reflective portion may cover all inclined pattern portions of the pattern portion. In particular, the reflective portion may fully cover the pattern portion.

The first angle may be equal to or different from the second angle.

The pattern portion may further include a first flat pattern portion connecting the first inclined pattern portion and the second inclined pattern portion and/or provided to be flat. The pattern portion may further include a second flat pattern portion spaced apart from the first flat pattern portion and/or connected to the second inclined pattern portion.

A width of the pattern portion may decrease in a direction from the reflective portion toward the substrate. That is, the pattern portion may be narrowing towards the substrate. The pattern portion may have a bowl-shape.

Each of the plurality of sub-pixels may include a light emission area disposed adjacent to a non-light emission area. The non-light emission area may surround the light emission areas of the plurality of sub-pixels.

The non-light emission area may include a circuit area disposed on one side of the light emission area.

The pattern portion may surround the remainder of the light emission area except for the one side of the light emission area on which the circuit area is disposed.

The pattern portion may be disposed on or formed on or formed in or formed by an overcoat layer disposed on the substrate. The pattern portion may be formed by the (upper) surface of the overcoat layer. The pattern portion may be part of the overcoat layer.

The plurality of sub-pixels may include a pixel electrode disposed on the overcoat layer. Each of the plurality of sub-pixels may include a pixel electrode disposed in the light-emission area and/or on the overcoat layer.

The first inclined pattern portion may be disposed adjacent to the pixel electrode.

The second inclined pattern portion may be spaced apart from the pixel electrode.

The display apparatus, in particular the plurality of sub-pixels, may further include a reflective electrode. The reflective portion may be a portion of the reflective electrode. The reflective electrode may be part of organic light emitting diodes formed in each of the sub-pixels.

The plurality of sub-pixels may further include an organic light emitting layer on the pixel electrode. The plurality of sub-pixels may further include a reflective electrode on the organic light emitting layer. The organic light emitting layer may be disposed on the pixel electrodes in the light emission areas of the sub-pixels and on the pattern portion in the non-light emission area. The reflective portion may be a portion of the reflective electrode and/or may extend from the reflective electrode and/or may be formed integrally with the reflective electrode.

The reflective portion may include a first inclined reflective portion disposed on the first inclined pattern portion.

The reflective portion may include a first flat reflective portion connected to the first inclined reflective portion and/or disposed on the first flat pattern portion.

The reflective portion may include a second inclined reflective portion connected to the first flat reflective portion and/or disposed on the second inclined pattern portion.

The reflective portion may include a second flat reflective portion connected to the second inclined reflective portion and/or disposed on the second flat pattern portion.

The display apparatus may further comprise an organic light emitting layer disposed on the pixel electrode.

The first angle $\theta_1$ may be provided to satisfy a mathematical expression below, wherein the letter $\theta_{c1}$ denotes an angle at which a portion of the light emitted by the organic light emitting layer is totally reflected between the pixel electrode and the overcoat layer:

$$\theta_1 > 90° - \theta_{c1}$$

The $\theta_{c1}$ may be provided to satisfy a mathematical expression below, wherein the letter $n_{oc}$ denotes a refractive index of the overcoat layer, and the letter $n_{Anode}$ denotes a refractive index of the pixel electrode.

$$\theta_{c1} = \arcsin(\frac{n_{oc}}{n_{Anode}})$$

When a portion of light emitted by the organic light emitting layer is not emitted to the outside of the substrate but trapped inside the substrate, the angle $\theta_s$ of a portion of light incident on the interface between the pixel electrode and the overcoat layer may be provided to satisfy a mathematical expression below, wherein the letter $\theta_1$ denotes the first angle, and the letter $\theta_{c1}$ denotes an angle at which a portion of the light emitted by the organic light emitting layer is totally reflected from the interface between the pixel electrodes and the overcoat layer.

$$270° - 2\theta_1 - \theta_{c1} > \theta_S$$

The first angle $\theta_1$ may be provided to satisfy a mathematical expression below, wherein the letter $n_{oc}$ denotes a refractive index of the overcoat layer, and the letter $n_{Anode}$ denotes a refractive index of the pixel electrode.

$$\theta_1 < 135° - 0.5\arcsin(\frac{n_{oc}}{n_{Anode}}) - 0.5\arcsin(\frac{n_{oc}}{n_{Anode}}\sin(\arcsin(\frac{1}{n_{oc}})))$$

The second angle $\theta_2$ may be provided to satisfy a mathematical expression below, wherein the letter $n_{oc}$ denotes a refractive index of the overcoat layer, and the letter $n_{air}$ denotes the refractive index of the outside air adjacent to the substrate.

$$\theta_2 < \arcsin(\frac{n_{air}}{n_{oc}})$$

The pattern portion may further comprise a third inclined pattern portion. The third inclined pattern portion may be disposed between the second inclined pattern portion and the substrate and/or disposed to have a third angle with respect to an upper surface of the substrate. The third inclined pattern portion may be disposed closer to the substrate than the second inclined pattern portion. The third inclined pattern portion may have a third angle with respect to the substrate. The second flat pattern portion may connect the second inclined pattern portion and the third inclined pattern portion.

The pattern portion may further comprise a third flat pattern portion. The third flat pattern portion may be spaced apart from the second flat pattern portion and/or connected to the third inclined pattern portion. The third flat pattern portion may extend from the third inclined pattern portion.

The third angle may be equal to or different from the second angle and/or the first angle.

The reflective portion may comprise a first inclined reflective portion disposed on the first inclined pattern portion.

The reflective portion may comprise a first flat reflective portion connected to the first inclined reflective portion and/or disposed on the first flat pattern portion.

The reflective portion may comprise a second inclined reflective portion connected to the first flat reflective portion and/or disposed on the second inclined pattern portion.

The reflective portion may comprise a second flat reflective portion connected to the second inclined reflective portion and/or disposed on the second flat pattern portion.

The reflective portion may comprise a third inclined reflective portion connected to the second flat reflective portion and/or disposed on the third inclined pattern portion.

The reflective portion may comprise a third flat reflective portion connected to the third inclined reflective portion and/or disposed on the third flat pattern portion.

The first inclined pattern portion may be directly connected to the second inclined pattern portion.

The first angle and the second angle may be different, and the first inclined pattern portion may be directly connected to the second inclined pattern portion.

The display apparatus may further comprise a connection point connecting the first inclined pattern portion and the second inclined pattern portion. The connection point may be disposed in the non-light emission area.

The reflective portion may comprise a first inclined reflective portion disposed on the first inclined pattern portion.

The reflective portion may comprise a second inclined reflective portion directly connected to the first inclined reflective portion and/or disposed on the second inclined pattern portion.

## BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:

FIG. 1 is a schematic plan view of a display apparatus according to one embodiment of the present disclosure.
FIG. 2 is a schematic plan view of one pixel illustrated in FIG. 1.
FIG. 3 is a schematic cross-sectional view of the line I-I' shown in FIG. 2.

FIG. 4 is a schematic cross-sectional view of the line II-II' shown in FIG. 2.

FIG. 5 is a schematic cross-sectional view of the line III-III' shown in FIG. 2.

FIG. 6 is a schematic enlarged cross-sectional view of portion A shown in FIG. 3

FIG. 7 is a schematic enlarged cross-sectional view illustrating a display apparatus according to another embodiment of the present disclosure, as another example of the portion A shown in FIG. 3.

FIG. 8A is an image illustrating light extraction characteristics of a display apparatus according to a comparative example.

FIG. 8B is an image illustrating light extraction characteristics of a display apparatus according to another comparative example.

FIG. 8C is an image illustrating light extraction characteristics of a display apparatus according to another embodiment of the present disclosure.

FIG. 9 is a graph depicting light intensity as a function of wavelength for a display apparatus according to another embodiment of the present disclosure compared to a display apparatus according to a comparative example.

FIG. 10 is a schematic enlarged cross-sectional view illustrating a display apparatus according to another embodiment of the present disclosure, as another example of the portion A shown in FIG. 3.

## DETAILED DESCRIPTION OF THE DISCLOSURE

Reference will now be made in detail to the embodiments of the present disclosure, examples of which are illustrated in the accompanying drawings. Wherever possible, the same reference numbers will be used throughout the drawings to refer to the same or like parts. Advantages and features of the present disclosure, and implementation methods thereof will be clarified through following embodiments described with reference to the accompanying drawings.

The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art.

A shape, a size, a ratio, an angle, and a number disclosed in the drawings for describing embodiments of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In a case where 'comprise', 'have', and 'include' described in the present specification are used, another part may be added unless 'only~' is used. The terms of a singular form may include plural forms unless referred to the contrary.

In construing an element, the element is construed as including an error range although there is no explicit description.

In describing a position relationship, for example, when a position relation between two parts is described as 'on~', 'over~', 'under~', and 'next~', one or more other parts may be disposed between the two parts unless 'just' or 'direct' is used.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms.

These terms are only used to distinguish one element from another. For example, a first element could be termed a second element, and, similarly, a second element could be termed a first element, without departing from the scope of the present disclosure.

"X-axis direction", "Y-axis direction" and "Z-axis direction" should not be construed by a geometric relation only of a mutual vertical relation and may have broader directionality within the range that elements of the present disclosure may act functionally.

The term "at least one" should be understood as including any and all combinations of one or more of the associated listed items. For example, the meaning of "at least one of a first item, a second item and a third item" denotes the combination of all items proposed from two or more of the first item, the second item and the third item as well as the first item, the second item or the third item.

Features of various embodiments of the present disclosure may be partially or overall coupled to or combined with each other and may be variously inter-operated with each other and driven technically as those skilled in the art can sufficiently understand. The embodiments of the present disclosure may be carried out independently from each other or may be carried out together in co-dependent relationship.

Hereinafter, the preferred embodiments of the present disclosure will be described in detail with reference to the accompanying drawings.

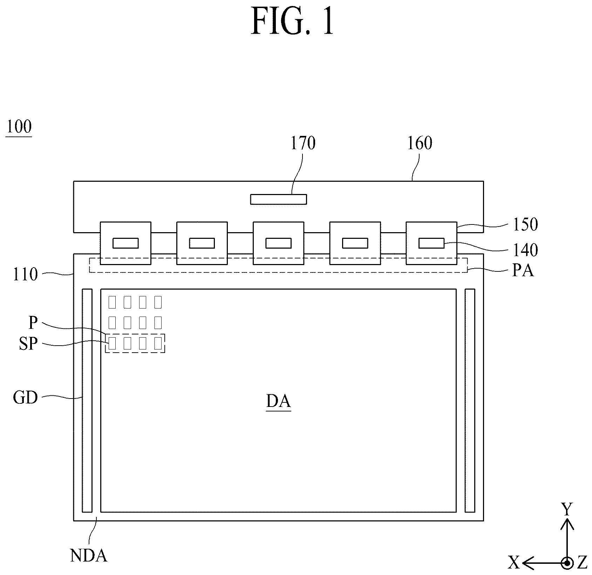

FIG. 1 is a schematic plan view of a display apparatus according to one embodiment of the present disclosure,

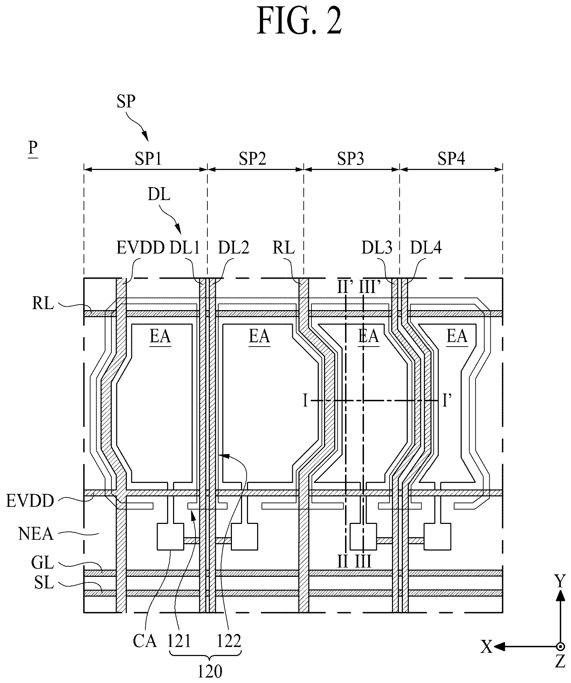

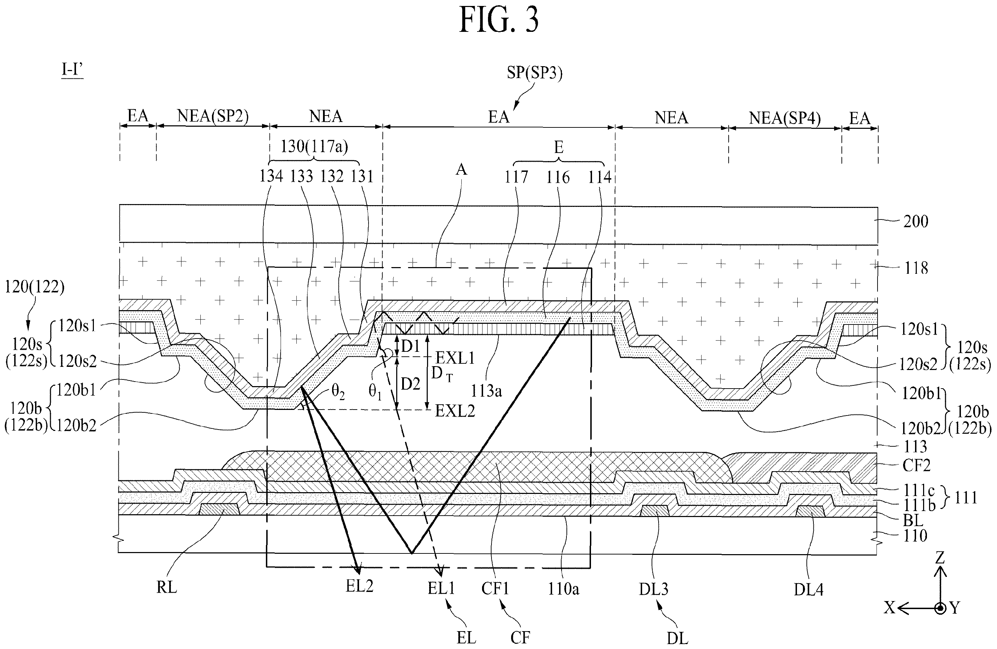

FIG. 2 is a schematic plan view of one pixel illustrated in FIG. 1, and FIG. 3 is a schematic cross-sectional view of the line I-I' shown in FIG. 2.

Referring now to FIGS. 1 to 3, a display apparatus 100 according to one embodiment of the present disclosure may include a substrate 110 including a plurality of pixels including a plurality of sub-pixels SPs, a pattern portion 120 disposed on the substrate 110 and concavely formed in a non-light emission area NEA between the plurality of sub-pixels SPs, and a reflective portion 130 disposed on the pattern portion 120.

The pattern portion 120 may be formed on an overcoat layer 113 disposed on the substrate 110. The pattern portion 120 according to one example may be concavely formed in the non-light emission area NEA by patterning and removing the overcoat layer 113 between a plurality of sub-pixels SPs. After the pattern portion 120 is formed to be concave, an organic light emitting layer 116 and a reflective electrode 117 may be sequentially deposited on the entire surface in a subsequent process. Thus, as shown in FIG. 3, the organic light emitting layer 116 and the reflective electrode 117 may be formed to be concave in the non-light emission area NEA along the profile of the pattern portion 120. Here, the reflective electrode 117 formed to be concave in the non-light emission area NEA may be the reflective portion 130. The pattern portion 120 according to one example may include a first inclined pattern portion 120s1 and a second inclined pattern portion 120s2. In addition, the pattern portion 120 may further include a first flat pattern portion 120b1 and a second flat pattern portion 120b2. The first inclined pattern portion 120s1 and the second inclined pattern portion 120s2 may be included on an inclined surface 120s of the pattern portion 120. The first flat pattern portion 120b1 and the second flat pattern portion 120b2 may be included on a flat surface 120b of the pattern portion 120.

The first inclined pattern portion 120s1 may be disposed at a first angle $\theta_1$ with respect to the upper surface 110a of the substrate 110. For example, the upper surface 110a of the substrate 110 may be disposed in a direction parallel to a first direction (X-axis direction). In one example, the first direction (X-axis direction) may be a horizontal direction with respect to FIG. 1. The horizontal direction may be a direction in which the gate wiring extends. The second direction (Y-axis direction), according to one example, is a direction intersecting the first direction (X-axis direction) and may be a perpendicular direction with respect to FIG. 1. The perpendicular direction may be a direction in which the data wiring extends. A third direction (Z-axis direction) according to one example may be a direction intersecting each of the first direction (X-axis direction) and the second direction (Y-axis direction), and may be a thickness direction of the display apparatus 100.

As shown in FIG. 3, the first extension line EXL1 is disposed in a direction parallel to the upper surface 110a of the substrate 110, so that the first inclined pattern portion 120s1 may be represented as being disposed at the first angle $\theta_1$ with respect to the first extension line EXL1. The first extension line EXL1 may refer to an imaginary line extending in the first direction (X-axis direction) from a point where the first inclined pattern portion 120s1 and the first flat pattern portion 120b1 contact. As the first inclined pattern portion 120s1 is disposed at the first angle $\theta_1$ with respect to the upper surface 110a of the substrate 110, the organic light emitting layer 116 and the reflective electrode 117 (or the reflective portion 130) formed on the first inclined pattern portion 120s1 may also be disposed at the first angle $\theta_1$ with respect to the upper surface 110a (or the first extension line EXL1) of the substrate 110.

The second inclined pattern portion 120s2 is disposed between the first inclined pattern portion 120s1 and the substrate 110 and may be disposed at a second angle $\Theta_z$ with respect to the upper surface 110a of the substrate 110. As shown in FIG. 3, the second extension line EXL2 is disposed in a direction parallel to the upper surface 110a of the substrate 110, so the second inclined pattern portion 120s2 may be represented as being disposed at the second angle $\Theta_z$ with respect to the second extension line EXL2. The second extension line EXL2 may refer to an imaginary line extending in the first direction (X-axis direction) from a point where the second inclined pattern portion 120s2 and the second flat pattern portion 120b2 contact. The second extension line EXL2 may be spaced apart from and parallel to the first extension line EXL1. As the second inclined pattern portion 120s2 is disposed at the second angle $\Theta_z$ with respect to the upper surface 110a of the substrate 110, the organic light emitting layer 116 and the reflective electrode 117 (or the reflective portion 130) formed on the second inclined pattern portion 120s2 may also be disposed at the second angle $\theta_2$ with respect to the upper surface 110a (or the second extension line EXL2) of the substrate 110.

On the other hand, the second inclined pattern portion 120s2 may be connected via the first flat pattern portion 120b1, which is flat and extending long in the first direction (X-axis direction). Thus, as shown in FIG. 3, the second inclined pattern portion 120s2 may be spaced apart from the first inclined pattern portion 120s1 in the first direction (X-axis direction). Since the second inclined pattern portion 120s2 is disposed lower than the first inclined pattern portion 120s1 in the third direction (Z-axis direction), it may be disposed closer to the upper surface 110a of the substrate 110 than the first inclined pattern portion 120s1.

The first flat pattern portion 120b1 according to an example may be flatly provided connecting the first inclined pattern portion 120s1 and the second inclined pattern portion 120s2. Accordingly, the first inclined pattern portion 120s1 and the second inclined pattern portion 120s2 may be spaced apart in the first direction (X-axis direction) by a length of the first flat pattern portion 120b1.

The second flat pattern portion 120b2, according to an example, may be spaced apart from the first flat pattern portion 120b1 and may be connected to the second inclined pattern portion 120s2. As shown in FIG. 3, the second flat pattern portion 120b2 may be flat. The second flat pattern portion 120b2 may be disposed lowest in the pattern portion 120, and thus may be referred as a bottom surface of the pattern portion 120. The second flat pattern portion 120b2 may be spaced apart from the first flat pattern portion 120b1 by a length (or component) of the first direction (X-axis direction) of the second inclined pattern portion 120s2. The second flat pattern portion 120b2 may be disposed spaced apart from the first flat pattern portion 120b1 by a length (or component) of the third direction (Z-axis direction) of the second inclined pattern portion 120s2. Alternatively, the second flat pattern portion 120b2 may be disposed spaced apart from the first flat pattern portion 120b1 by a thickness (or second thickness D2) of the overcoat layer 113 in which the second inclined pattern portion 120s2 is formed.

The width of the pattern portion 120 according to one example may decrease in the direction from the reflective portion 130 toward the substrate 110. Thus, the width of the pattern portion 120 surrounded by the second inclined pattern portion 120s2 may be narrower than the width of the pattern portion 120 surrounded by the first inclined pattern portion 120s1. In other words, the pattern portion 120 may be provided in the form of a bowl in which the width of the groove narrows as it goes downward in the third direction (Z-axis direction).

In the display apparatus 100 according to one embodiment of the present disclosure, the first inclined pattern portion 120s1 and the second inclined pattern portion 120s2 may be disposed in the non-light emission area NEA. Therefore, the display apparatus 100 according to one embodiment of the present disclosure may reflect light emitted from the organic light emitting layer 116 and directed toward the adjacent sub-pixel SP through the reflective portion 130 disposed on the first inclined pattern portion 120s1 and the second inclined pattern portion 120s2, so that the light extraction efficiency can be improved.

Furthermore, since the display apparatus 100 according to one embodiment of the present disclosure may extract light from the non-light emission area NEA that is a periphery of the light emission area EA through the reflective portion 130 disposed on the pattern portion 120 (or the first inclined pattern portion 120s1 and the second inclined pattern portion 120s2), compared to a display apparatus without the pattern portion 120 and/or the reflective portion 130, the same luminous efficiency may be achieved with lower power, or the luminous efficiency may be further improved, resulting in lower overall power consumption.

Furthermore, the display apparatus 100 according to one embodiment of the present disclosure may have the same light emitting efficiency with lower power, thus the lifetime of the light emitting element layer E (or organic light emitting layer 116) (shown in FIG. 3) may be improved.

Referring now to FIG. 3, in the display apparatus 100 according to one embodiment of the present disclosure, reflective light EL reflected by the reflective portion 130 may include a first reflected light EL1 (or WG mode extracted light EL1) and a second reflected light EL2 (or substrate mode extracted light EL2). The first reflected light EL1 (or WG mode extracted light EL1) is emitted from the organic light emitting layer 116, wave guided through being totally reflected from interfaces between the pixel electrode 114 and the overcoat layer 113, and the reflective electrode 117, then reflected from the reflective portion 130 and directed to the substrate 110. The second reflected light (EL2) (or substrate mode extracted light (EL2)) is emitted from the organic light emitting layer 116, firstly reflected from the interface between the lower surface of the substrate 110 and outside air, then secondly reflected from the reflective portion 130 and directed to the substrate 110. In FIG. 3, the first reflected light EL1 shown as a dash line and the second reflected light EL2 shown as a solid line may be reflected light that is reflected by the reflective portion 130 and extracted to the outside of the substrate 110.

As shown in FIG. 3, the first reflective light EL1 according to an example may be reflected by the reflective portion 130 and emitted from the light emission area EA. The second reflected light EL2 may be emitted at a location spaced apart from the light emission area EA. For example, the second reflected light EL2 may be emitted from the non-light emission area NEA or a periphery of the light emission area EA (or a periphery area). However, it is not necessarily limited thereto, and the first reflected light EL1 may be emitted toward the substrate 110 from a location (or non-light emission area NEA) spaced apart from the light emission area EA, and the second reflected light EL2 may be emitted from the light emission area EA.

Hereinafter, reference to FIGS. 1 and 2, the display apparatus 100 according to an embodiment of the present specification will be described in more detail.

Referring to FIGS. 1 and 2, the display apparatus 100 according to one embodiment of the present disclosure may include a display panel having a gate driver GD, a source drive integrated circuit (hereinafter, referred to as "IC") 140, a flexible film 150, a circuit board 160, and a timing controller 170.

The display panel may include a substrate 110 and an opposite substrate 200 (shown in FIG. 3).

The substrate 110 may include a thin film transistor, and may be a transistor array substrate, a lower substrate, a base substrate, or a first substrate. The substrate 110 may be a transparent glass substrate or a transparent plastic substrate. The substrate 110 may include a display area DA and a non-display area NDA.

The display area DA is an area where an image is displayed, and may be a pixel array area, an active area, a pixel array unit, a display unit, or a screen. For example, the display area DA may be disposed at a central portion of the display panel. The display area DA may include a plurality of pixels P.

The opposite substrate 200 may encapsulate (or seal) the display area DA disposed on the substrate 110. For example, the opposite substrate 200 may be bonded to the substrate 110 via an adhesive member (or clear glue). The opposite substrate 200 may be an upper substrate, a second substrate, or an encapsulation substrate. The opposite substrate 200 may comprise a metal layer that is magnetic, such as Invar, SUS, or the like. Alternatively, the opposite substrate 200 may be composed of multiple layers, such as a metal layer for good heat dissipation, such as Aluminum, an organic adhesive layer for adhesion, and an organic protective layer that is thicker than the metal layer for improved encapsulating performance.

The gate driver GD supplies gate signals to the gate lines in accordance with the gate control signal input from the timing controller 170. The gate driver GD may be formed on one side of the light emission area EA or in the non-light emission area NEA outside both sides of the light emission area EA in a gate driver in panel (GIP) method, as shown in FIG. 1.

The non-display area NDA is an area on which an image is not displayed, and may be a peripheral area, a signal supply area, an inactive area or a bezel area. The non-display area NDA may be configured to be in the vicinity of the display area DA. That is, the non-display area NDA may be disposed to surround the display area DA.

A pad area PA may be disposed in the non-display area NDA. The pad area PA may supply a power source and/or a signal for outputting an image to the pixel P provided in the display area DA. Referring to FIG. 1, the pad area PA may be provided above the display area DA.

The source drive IC 140 receives digital video data and a source control signal from the timing controller 170. The source drive IC 140 converts the digital video data into analog data voltages in accordance with the source control signal and supplies the analog data voltages to the data lines. When the source drive IC 140 is manufactured as a driving chip, the source drive IC 140 may be packaged in the flexible film 150 in a chip on film (COF) method or a chip on plastic (COP) method.

Pads, such as data pads, may be formed in the non-display area NDA of the display panel. Lines connecting the pads with the source drive IC 140 and lines connecting the pads with lines of the circuit board 160 may be formed in the flexible film 150. The flexible film 150 may be attached onto the pads by using an anisotropic conducting film, whereby the pads may be connected with the lines of the flexible film 150.

The circuit board 160 may be attached to the flexible films 150. A plurality of circuits implemented as driving chips may be packaged in the circuit board 160. For example, the timing controller 170 may be packaged in the circuit board 160. The circuit board 160 may be a printed circuit board or a flexible printed circuit board.

The timing controller 170 receives the digital video data and a timing signal from an external system board through a cable of the circuit board 160. The timing controller 170 generates a gate control signal for controlling an operation timing of the gate driver GD and a source control signal for controlling the source drive ICs 140 based on the timing signal. The timing controller 170 supplies the gate control signal to the gate driver GD, and supplies the source control signal to the source drive ICs 140.

Referring to FIGS. 2 and 3, the substrate 110 according to an example may include the light emission area EA and the non-light emission area NEA.

The light emission area EA may mean an area from which light is emitted. A light emitting element layer E, which includes a pixel electrode 114, an organic light emitting layer 116 and a reflective electrode 117, may be disposed in the light emission area EA. When an electric field is formed between the pixel electrode 114 and the reflective electrode 117, the organic light emitting layer 116 in the light emission area EA may emit light.

As shown in FIG. 3, an optical path of a portion of the light emitted by the organic light emitting layer 116 may be formed toward an adjacent sub-pixel (or non-emitting sub-pixel) through the organic light emitting layer 116 and the pixel electrode 114, which are disposed between the reflective electrodes 117 and the upper surface 113a of the overcoat layer 113, and/or through the overcoat layer 113. The display apparatus 100 according to one embodiment of the present disclosure may have the reflective portion 130 disposed between the sub-pixels SPs, thus the reflective portion 130 may reflect light directing to the adjacent sub-pixels toward the non-light emission area NEA or the light emission area EA or toward the emitting sub-pixels. Accordingly, the display apparatus 100 according to one embodiment of the present disclosure may improve the light extraction efficiency of the emitting sub-pixel by extracting the light directed toward the adjacent sub-pixel through the reflective portion 130. Furthermore, the display apparatus 100 according to one embodiment of the present disclosure may be prevented from color mixing due to the reflective portion 130 disposed between the sub-pixels SP.

As a result, the display apparatus 100 according to one embodiment of the present disclosure may have an overall improved light efficiency while preventing color mixing with adjacent sub-pixels (or adjacent, non-emitting sub-pixels) through the reflective portion 130 disposed on the pattern portion 120 of the non-light emission area NEA.

Referring back to FIG. 2, the light emission area EA according to an example may include gate lines, data lines, pixel driving power lines, and a plurality of pixels P. Each of the plurality of pixels P may include a plurality of subpixels SP that may be defined by the gate lines and the data lines.

At least four subpixels, which are provided to emit different colors and disposed to be adjacent to one another, among the plurality of subpixels SP may constitute one pixel P (or unit pixel). One pixel P may include, but is not limited to, a red subpixel, a white subpixel, a blue subpixel and a green subpixel. One pixel P may include three subpixels SP provided to emit light of different colors and disposed to be adjacent to one another. For example, one pixel P may include a red subpixel, a green subpixel and a blue subpixel.

Each of the plurality of subpixels SP includes a thin film transistor and a light emitting element layer E connected to the thin film transistor. Each of the plurality of subpixels may include a light emitting layer (or an organic light emitting layer) interposed between the pixel electrode and the reflective electrode.

The light emitting layers disposed in each of the plurality of sub-pixels SP may emit white light in common. Since the light emitting layer of each of the plurality of sub-pixels SP emits white light in common, each of the red sub-pixel, the green sub-pixel, and the blue sub-pixel may include a color filter CF (or wavelength conversion member CF) that converts the white light to the respective colored light. In this case, the white sub-pixel may not comprise a color filter.

In the display apparatus 100 according to one embodiment of the present disclosure, the area with the red color filter may be a red sub-pixel or a first sub-pixel, the area without the color filter may be a white sub-pixel or a second sub-pixel, the area with the blue color filter may be a blue sub-pixel or a third sub-pixel, and the area with the green color filter may be a green sub-pixel or a fourth sub-pixel.

Each of the subpixels SP supplies a predetermined current to the organic light emitting element in accordance with a data voltage of the data line when a gate signal is input from the gate line by using the thin film transistor. For this reason, the light emitting layer of each of the subpixels may emit light with a predetermined brightness in accordance with the predetermined current.

The plurality of subpixels SP according to one example may be disposed to be adjacent to each other in a first direction (X-axis direction).

The plurality of subpixels SP may include a first subpixel SP1, a second subpixel SP2, a third subpixel SP3 and a fourth subpixel SP4 arranged adjacent to each other in the first direction (X-axis direction). For example, the first subpixel SP1 may be a red subpixel, the second subpixel SP2 may be a white subpixel, the third subpixel SP3 may be a blue subpixel and the fourth subpixel SP4 may be a green subpixel, but is not limited thereto. However, the arrangement order of the first subpixel SP1, the second subpixel SP2, the third subpixel SP3 and the fourth subpixel SP4 may be changed.

Each of the first to fourth subpixels SP1 to SP4 may include a light emission area EA and a circuit area CA. The light emission area EA may be disposed at one side (or an upper side) of a sub-pixel area, and the circuit area CA may be disposed at the other side (or a lower side) of the subpixel area. For example, the circuit area CA may be disposed at one side (or the lower side) of the light emission area EA based on the second direction (Y-axis direction). The light emission area EA of each of the first to fourth sub-pixels SP1 to SP4 may have the same size (or area) or different sizes (or areas) from each other.

The first to fourth subpixels SP1 to SP4 may be disposed to be adjacent to one another along the first direction (X-axis direction). For example, two data lines DL extended long along the second direction (Y-axis direction) may be disposed in parallel with each other between the first subpixel SP1 and the second subpixel SP2 and between the third subpixel SP3 and the fourth sub-pixel SP4. A pixel power line EVDD (or branch wiring of the pixel power line) extended along the first direction (X-axis direction) may be disposed between the light emission area EA and the circuit area CA of each of the first to fourth subpixels SP1 to SP4. The gate line GL and a sensing line SL may be disposed below the circuit area CA. The pixel power line EVDD (shown in FIG. 2) extended along the second direction (Y-axis direction) may be disposed at one side of the first subpixel SP1 or the fourth subpixel SP4. A reference line RL extended long along the second direction (Y-axis direction) may be disposed between the second subpixel SP2 and the third subpixel SP3. The reference line RL may be used as a sensing line for sensing a change of characteristics of a driving thin film transistor and/or a change of characteristics of the light emitting element layer, which is disposed in the circuit area, from the outside in a sensing driving mode of the pixel P. In one example, the data lines DL are for supplying data signals to each of the plurality of the sub-pixels SP to drive each of the plurality of the sub-pixels SP. For example, the data lines DL may include a first data line DL1 for driving a first sub-pixel SP1, a second data line DL2 for driving a second sub-pixel SP2, a third data line DL3 for driving a third sub-pixel SP3, and a fourth data line DL4 for driving a fourth sub-pixel SP4.

In the display apparatus 100 according to one embodiment of the present disclosure, the data lines may be disposed not to overlap the light emission area EA. For example, the third data line DL3 may be arranged such that it does not overlap the light emission area EA. Thus, in the display apparatus 100 according to one embodiment of the present disclosure, the third data line DL3 does not overlap (or is not interfered with) light emitted from the light emission area EA, thus a decrease in light extraction efficiency may be prevented. The first data line DL1, the second data line DL2, and the fourth data line DL4, like the third data line DL3, may be disposed in the non-light emission area NEA of the corresponding sub-pixel no to be overlapped the light emission area EA of the corresponding sub-pixel in the third direction (Z-axis direction). Thus, in the display apparatus 100 according to one embodiment of the present disclosure, the data lines DL1, DL2, DL3, DL4 may have a structural feature that do not overlap the light emission area EA but overlap the non-light emission area NEA.

On the other hand, each of the pixel power line EVDD and the reference line RL may be disposed in the non-light emission area NEA so as not to obscure (or interfere with) light emitted from the light emission area EA, such as the data lines described above.

In the display apparatus 100 according to one embodiment of the present disclosure, each of the plurality of the sub-pixels SP may include the light emission area EA disposed adjacent to the non-light emission area NEA. As shown in FIG. 3, the reflective portion 130 may be spaced apart from the light emission area EA. This is because if the reflective portion 130 is not spaced apart from the light emission area and is disposed adjacent to the light emission area or overlapped with the light emission area, the light emitted from the light emission area EA is not able to be reflected by the reflective portion 130.

Thus, in the display apparatus 100 according to one embodiment of the present disclosure, the reflective portion 130 is spaced apart from the light emission area EA, such that light directed to an adjacent sub-pixel (e.g., the second sub-pixel SP2) among the light emitted from the light emission area EA may be reflected by the reflective portion 130, thereby improving light extraction efficiency.

On the other hand, as shown in FIG. 3, the light emission area EA is an area defined by the pixel electrode 114 disposed on the overcoat layer 113, so the reflective portion 130 may be spaced apart from the pixel electrode 114. In contrast, since the pixel electrode 114 is formed on the upper surface 113a of the overcoat layer 113, the first inclined pattern portion 120s1 of the pattern portion 120 may be disposed adjacent to the pixel electrode 114. For example, the first inclined pattern portion 120s1 may be disposed adjacent to an edge of a lower surface of the pixel electrode 114. The second inclined pattern portion 120s2 may be spaced apart from the first inclined pattern portion 120s1 in the first direction (X-axis direction), and thus may be spaced apart from the pixel electrode 114.

In the display apparatus 100 according to one embodiment of the present disclosure, the overcoat layer 113 (or the first overcoat layer) on which the first inclined pattern portion 120s1 is formed may be provided to have a first thickness D1. Also, the overcoat layer 113 (or the second overcoat layer) in which the second inclined pattern portion 120s2 is formed may be provided to have a second thickness D2. In FIG. 3, the first thickness D1 may be provided to be thinner than the second thickness D2, but is not necessarily limited thereto, and the first thickness D1 may be provided to be equal to or thicker than the second thickness D2 depending on the optimal design for improving the light extraction efficiency. A sum of the first thickness D1 and the second thickness D2 may be the total thickness DT of the overcoat layer 113 on which the first inclined pattern portion 120s1 and the second inclined pattern portion 120s2 are disposed.

Referring again to FIG. 3, the display apparatus 100 according to one embodiment of the present disclosure may be provided with the first angle $\theta_1$ equal to or different from the second angle $\theta_2$. For example, when the first angle $\theta_1$ is equal to the second angle $\theta_2$, the reflective portion 130 on the first inclined pattern portion 120s1 and the reflective portion 130 on the second inclined pattern portion 120s2 may be disposed at the same angle with respect to the upper surface 110a of the substrate 110 to reflect light directed to an adjacent sub-pixel toward the emitting sub-pixel. For example, if the first angle $\theta_1$ is different from the second angle $\theta_2$, the reflective portion 130 on the first inclined pattern portion 120s1 and the reflective portion 130 on the second inclined pattern portion 120s2 may be disposed at different angles (or multiple angles) with respect to the upper surface 110a of the substrate 110 to reflect light directed to adjacent1 sub-pixels toward the emitting sub-pixel. In other words, the display apparatus 100 according to one embodiment of the present disclosure may be provided with multiple surfaces (or multiple inclined surfaces) in which the reflective portions 130 have different angles.

On the other hand, when the first angle $\theta_1$ is larger than the second angle $\theta_2$, light may be more likely not to be directed onto the reflective portion 130 (or a second inclined reflective portion 133) on the second inclined pattern portion 120s2 by the waveguide, but to be reflected from the reflective portion 130(or the first inclined reflective portion 131) disposed on the first inclined pattern portion 120s1 and extracted to the outside of the substrate 110.

In the case of a general display apparatus having a single side with a reflective portion disposed to be spaced apart position from the pixel electrode, when the angle formed between the upper surface of the substrate and the reflective portion (or the inclined plane of the overcoat layer adjacent to the pixel electrode) is large, the light directed to the adjacent sub-pixel by the wave guide can be reflected by the reflective portion, thereby having the advantage of high light extraction efficiency. However, there is a disadvantage that the light totally reflected from the interface (or boundary) between the substrate and the outside air is reflected by the reflective portion, then is not directly extracted to the outside of the substrate, but is totally reflected from the inside of the substrate through being reflected from the cathode (or counter electrode), and there is a high probability that it cannot be extracted to the outside.

Furthermore, in the case of a general display apparatus having a single side with a reflective portion 130 disposed to be spaced apart from the pixel electrode 114, if the angle formed between the upper surface 110a of the substrate 110 and the reflective portion 130(or the inclined plane of the overcoat layer 113 adjacent to the pixel electrode 114) is small, the light totally reflected from the interface (or boundary) between the substrate 110 and the outside air may be directly extracted to the outside of the substrate after being reflected by the reflective portion 130, which has the advantage of high light extraction efficiency. However, there is a disadvantage that light directed to an adjacent sub-pixel by the wave guide is likely to be totally reflected between the reflective portion 130 and the overcoat layer 113 and not be extracted to the outside. In other words, the wave-guided light may not escape the critical angle (or the wave-guided light may have an angle greater than the critical angle) and may be guided along the inclined surface of the reflective portion 130 and/or the overcoat layer 113 and may not be extracted to the outside.

Thus, the display apparatus 100 according to one embodiment of the present disclosure is provided with inclined surfaces of the pattern portion 120 (or first and second inclined pattern portions 120s1, 120s2) at multiple angles (first angle $\theta_1$ and second angle $\theta_2$) with respect to the upper surface 110a of the substrate 110, thus both the light that is extinguished by the wave guide and the light that is totally reflected and extinguished inside the substrate 110 may be output to the outside in the form of the first reflected light EL1 and the second reflected light EL2, the light extraction efficiency may be maximized.

As a result, in the display apparatus 100 according to one embodiment of the present specification, light that is extinguished by the wave guide may be directed to the outside of the substrate 110 by the first overcoat layer having a first thickness D1 and the first inclined pattern portion 120s1 (or the first inclined reflective portion 131) having the first angle $\theta_1$. Also, the light that is trapped within the substrate 110 and is extinguished may be directed to the outside of the substrate 110 by the second overcoat layer provided with the second thickness D2 and the second inclined pattern portion 120s2 (or the second inclined reflective portion 133) provided with the second angle $\theta_2$. Alternatively, light that is trapped within the substrate 110 and extinguished may be directed to the outside of the substrate 110, due to a thickness DT of the overcoat layer 113, and the second inclined pattern portion 120s2 (or the second inclined reflective portion 133). Here, the thickness DT is a thickness of the overcoat layer 113 including the first inclined pattern portion 120s1 and the second inclined pattern portion 120s2, and the second inclined pattern portion 120s2 is provided at the second angle $\theta_2$.

On the other hand, in the display apparatus 100 according to one embodiment of the present disclosure, the pattern portion 120 may be provided to surround the remainder of the light emission area EA except for one side of the light emission area EA where the circuit area CA is provided. For example, as shown in FIG. 2, the pattern portion 120 may not be disposed only on one side of the light emission area EA adjacent to the circuit area CA but may be disposed only on the remainder of the light emission area EA. This is because the pixel electrode 114 disposed in the light emission area EA needs to be connected to the circuit area CA, thus the pattern portion 120 is not able to be formed between the light emission area EA and the circuit area CA. Accordingly, the pattern portion 120 is able to be disposed only in the area where the pattern portion 120 is formed. Therefore, as shown in FIG. 2, the display apparatus 100 according to one embodiment of the present disclosure may have a structural feature in which the pattern portion 120 is disposed to surround the remainder of the light emission area EA except for one side of the light emission area EA where the circuit area CA is provided.

Referring to FIG. 2, the pattern portion 120 may include a first pattern line 121 disposed long in the first direction (X-axis direction) between the circuit area CA and the light emission area EA and a second pattern line 122 disposed long in the second direction (Y-axis direction) crossing the first direction (X-axis direction). Referring to FIG. 2, the first pattern line 121 may mean the pattern portion 120 disposed in a horizontal direction, and the second pattern line 122 may mean the pattern portion 120 disposed in a vertical direction.

The first pattern line 121 may include a bottom surface 121b and an inclined surface 121s. The second pattern line 122 may include a bottom surface 122b and an inclined surface 122s. Since each of the bottom surface 121b and the inclined surface 121s of the first pattern line 121 and each of the bottom surface 122b and the inclined surface 122s of the second pattern line 122 are the same as each of the bottom surface 120b and the inclined surface 120s of the pattern portion 120, their description will be omitted. The first pattern line 121 and the second pattern line 122 may be connected to one in the non-light emission area NEA (or the peripheral area) to surround the light emission area EA.

The first pattern line 121 may be disposed between the subpixels SP for emitting light of the same color. For example, the first pattern line 121 may be disposed between the first subpixels SP1 disposed in the second direction (Y-axis direction). Therefore, the first pattern line 121 may be disposed long in the first direction (X-axis direction). In contrast, the second pattern line 122 may be disposed between the subpixels SP for emitting light of different colors. For example, the second pattern line 122 may be disposed between the third subpixel SP3 that is a blue subpixel, and the fourth subpixel SP4 that is a green pixel. Therefore, the second pattern line 122 may be disposed long in the second direction (Y-axis direction).

Since the second pattern line 122 is disposed between the subpixels SP for emitting light of different colors, the reflective portion 130 on the second pattern line 122 may prevent light of different colors from being emitted to other adjacent subpixels SP. Therefore, the display apparatus 100 according to the present disclosure may prevent color mixture (or color distortion) between the sub-pixels SP for emitting light of different colors, thereby improving color purity.

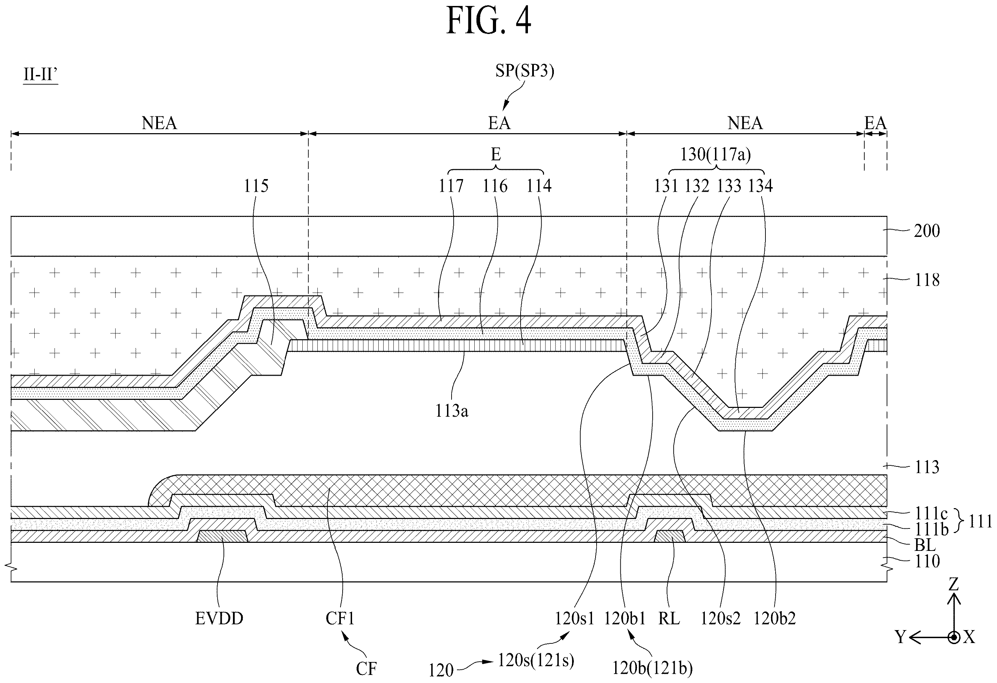

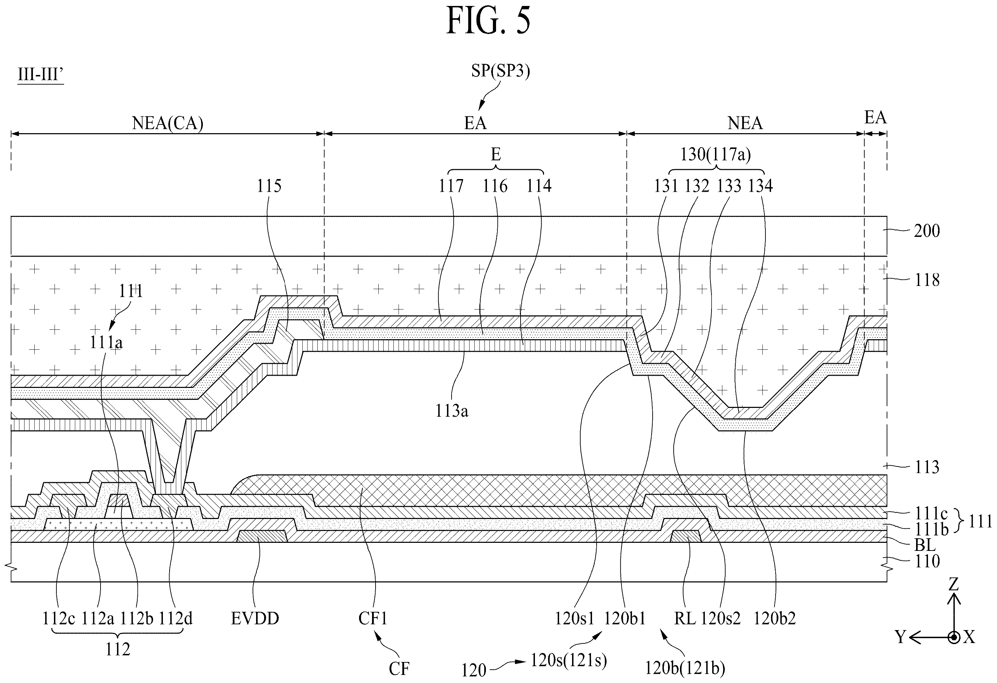

FIG. 4 is a schematic cross-sectional view of the line II-II' shown in FIG. 2, and FIG. 5 is a schematic cross-sectional view of the line III-III' shown in FIG. 2.

Referring to FIGS. 4 and 5, in the non-light emission area NEA where the circuit area CA is disposed, the bank 115 may be disposed to cover the circuit area CA (or the thin film transistor 112, shown in FIG. 5). Each of the pixel power line EVDD and the reference line RL may be disposed so as not to overlap the light emission area EA in the third direction (Z-axis direction). Accordingly, the display apparatus 100 according to one embodiment of the present disclosure may enable light emitted from the light emission area EA to be directed to the outside of the substrate 110 without interference from the pixel power lines EVDD and the reference line RL, so that a decrease in light emission efficiency may be prevented.

Hereinafter, referring to FIG. 5, a structure of each of the plurality of subpixels SP will be described in detail.

Referring to FIG. 5, the display apparatus 100 according to one embodiment of the present disclosure may further include a buffer layer BL, a circuit element layer 111, a thin film transistor 112, an overcoat layer 113, a pixel electrode 114, a bank 115, an organic light emitting layer 116, a reflective electrode 117, an encapsulation layer 118 and a color filter CF.

In more detail, each of the subpixels SP according to one embodiment may include a circuit element layer 111 provided on an upper surface of a buffer layer BL, including a gate insulating layer 111a, an interlayer insulating layer 111b and a passivation layer 111c, an overcoat layer 113 provided on the circuit element layer 111, a pixel electrode 114 provided on the overcoat layer 113, a bank 115 covering an edge of the pixel electrode 114, an organic light emitting layer 116 on the pixel electrode 114 and the bank 115, a reflective electrode 117 on the organic light emitting layer 116, and an encapsulation layer 118 on the reflective electrode 117.

The thin film transistor 112 for driving the subpixel SP may be disposed on the circuit element layer 111. The circuit element layer 111 may be expressed as the term of an inorganic film layer. The buffer layer BL may be included in the circuit element layer 111 together with the gate insulating layer 111a, the interlayer insulating layer 111b and the passivation layer 111c. The pixel electrode 114, the organic light emitting layer 116 and the reflective electrode 117 may be included in the light emitting element layer E.

The buffer layer BL may be formed between the substrate 110 and the gate insulating layer 111a to protect the thin film transistor 112. The buffer layer BL may be disposed on the entire surface (or front surface) of the substrate 110. The pixel power line EVDD for pixel driving may be disposed between the buffer layer BL and the substrate 110. The pixel power line EVDD may be disposed below the bank 115 while being spaced apart from the thin film transistor 112. The reference line RL may also be disposed between the buffer layer BL and the substrate 110. The reference line RL may be disposed in the non-light emission area NEA that does not overlap with the light emission area EA. The buffer layer BL may serve to block diffusion of a material contained in the substrate 110 into a transistor layer during a high temperature process of a manufacturing process of the thin film transistor. Optionally, the buffer layer BL may be omitted in some cases.

The thin film transistor 112 (or a drive transistor) according to an example may include an active layer 112a, a gate electrode 112b, a source electrode 112c, and a drain electrode 112d.

The active layer 112a may include a channel area, a drain area and a source area, which are formed in a thin film transistor area of a circuit area of the subpixel SP. The drain area and the source area may be spaced apart from each other with the channel area interposed therebetween.

The active layer 112a may be formed of a semiconductor material based on any one of amorphous silicon, polycrystalline silicon, oxide and organic material.

The gate insulating layer 111a may be formed on the channel area of the active layer 112a. As an example, the gate insulating layer 111a may be formed in an island shape only on the channel area of the active layer 112a, or may be formed on an entire front surface of the substrate 110 or the buffer layer BL, which includes the active layer 112a.

The gate electrode 112b may be formed on the gate insulating layer 111a to overlap the channel area of the active layer 112a.

The interlayer insulating layer 111b may be formed on the gate electrode 112b and the drain area and the source area of the active layer 112a. As in Figure 5, the interlayer insulating layer 111b may be formed in the circuit area and an entire light emission area, in which light is emitted to the subpixel SP. However, embodiments of the present disclosure are not limited thereto, the interlayer insulating layer 111b may be patterned between the drain electrode 112d and the gate electrode 112b and drain region of the active layer 112a and may be arranged in an island shape, and moreover, may be patterned between the source electrode 112c and the gate electrode 112b and source region of the active layer 112a and may be arranged in an island shape.

The source electrode 112c may be electrically connected to the source area of the active layer 112a through a source contact hole provided in the interlayer insulating layer 111b overlapped with the source area of the active layer 112a. The drain electrode 112d may be electrically connected to the drain area of the active layer 112a through a drain contact hole provided in the interlayer insulating layer 111b overlapped with the drain area of the active layer 112a.

The drain electrode 112d and the source electrode 112c may be made of the same metal material. For example, each of the drain electrode 112d and the source electrode 112c may be made of a single metal layer, a single layer of an alloy or a multi-layer of two or more layers, which is the same as or different from that of the gate electrode.

In addition, the circuit area may further include first and second switching thin film transistors disposed together with the thin film transistor 112, and a capacitor. Since each of the first and second switching thin film transistors is provided on the circuit area of the subpixel SP to have the same structure as that of the thin film transistor 112, its description will be omitted. The capacitor (not shown) may be provided in an overlap area between the gate electrode 112b and the source electrode 112c of the thin film transistor 112, which overlap each other with the interlayer insulating layer 111b interposed therebetween.

Additionally, in order to prevent a threshold voltage of the thin film transistor provided in a pixel area from being shifted by light, the display panel or the substrate 110 may further include a light shielding layer (not shown) provided below the active layer 112a of at least one of the thin film transistor 112, the first switching thin film transistor or the second switching thin film transistor. The light shielding layer may be disposed between the substrate 110 and the active layer 112a to shield light incident on the active layer 112a through the substrate 110, thereby minimizing a change in the threshold voltage of the transistor due to external light. Also, since the light shielding layer is provided between the substrate 110 and the active layer 112a, the thin film transistor may be prevented from being seen by a user.

The passivation layer 111c may be provided on the substrate 110 to cover the pixel area. The passivation layer 111c covers a drain electrode 112d, a source electrode 112c and a gate electrode 112b of the thin film transistor 112, and the buffer layer BL.

On the other hand, the display apparatus 100 according to one embodiment of the present disclosure may be provided that the bank 115 is disposed only on one side of the light emission area EA in which the circuit area CA is disposed. Accordingly, as shown in FIG. 5, the pixel power line EVDD may be disposed to overlap the bank 115 in the third direction (Z-axis direction), and the reference line RL may not overlap the bank 115 in the third direction (Z-axis direction). The passivation layer 111c may be formed over the circuit area and the light emission area. The passivation layer 111c may be omitted. The color filter CF may be disposed on the passivation layer 111c.

The overcoat layer 113 may be provided on the substrate 110 to cover the passivation layer 111c and the color filter CF. When the passivation layer 111c is omitted, the overcoat layer 113 may be provided on the substrate 110 to cover the circuit area. The overcoat layer 113 may be formed in the circuit area CA in which the thin film transistor 112 is disposed and the light emission area EA. In addition, the overcoat layer 113 may be formed in the other non-display area NDA except a pad area PA of the non-display area NDA and the entire display area DA. For example, the overcoat layer 113 may include an extension portion (or an enlarged portion) extended or enlarged from the display area DA to the other non-display area NDA except the pad area PA. Therefore, the overcoat layer 113 may have a size relatively wider than that of the display area DA.

The overcoat layer 113 according to one example may be formed to have a relatively thick thickness, thereby providing a flat surface on the display area DA and the non-display area NDA. For example, the overcoat layer 113 may be made of an organic material such as photo acryl, benzocyclobutene, polyimide and fluorine resin.

By being provided with a upper surface 113a of the overcoat layer 113 to be flat, the pixel electrodes 114 on the overcoat layer 113 may also be provided to be flat, and the organic light emitting layer 116 and reflective electrodes 117 formed thereon may also be provided to be flat. Since the pixel electrode 114, the organic light emitting layer 116, the reflective electrode 117, that is, the light emitting element layer E is provided to be flat in the light emission area EA, a thickness of each of the pixel electrode 114, the organic light emitting layer 116 and the reflective electrode 117 in the light emission area EA may be uniformly formed. Therefore, the organic light emitting layer 116 may be uniformly emitted without deviation in the light emission area EA.

On the other hand, the pattern portion 120 may be formed by patterning and removing a portion of the overcoat layer 113. The pattern portion 120, according to one example, may be formed on the overcoat layer 113 by a photo process utilizing a mask having an opening, and by a patterning (or etching) or ashing process after the photo process. As described above, the pattern portion 120 may include a first pattern line 121 and a second pattern line 122, and the first pattern line 121 and the second pattern line 122 may be disposed to surround the remainder of the light emission area EA except for one side of the light emission area EA to which the circuit area CA is adjacent. After the pattern portion 120 is formed, the pixel electrodes 114 on the overcoat layer 113 may be formed in a pattern for each sub-pixel SP, and then the organic light emitting layer 116 and the reflective electrodes 117 may be formed on the entire surface.

Referring again to FIG. 5, the color filter CF disposed in the light emission area EA may be provided between the substrate 110 (or passivation layer 111c) and the overcoat layer 113. Accordingly, color filter CF may be disposed between the reference line RL and the reflective portion 130 or between the reference line RL and the pattern portion 120. The color filter CF may include a red color filter (or a third color filter) (not shown) that converts white light emitted by the organic light emitting layer 116 into red light, a blue color filter (or a first color filter) (CF1) (shown in FIG. 3) that converts white light into blue light, and a green color filter (or a second color filter) (CF2) that converts white light into green light. The second sub-pixel SP2, which is a white sub-pixel, may not include a color filter because the organic light emitting layer 116 emits white light.

As shown in FIG. 3, the display apparatus 100 according to one embodiment of the present disclosure may be provided such that color filters (e.g., the first color filter (CF1) and the second color filter (CF2)) having different colors partially overlap each other at a boundary portion of the plurality of subpixels SP. In this case, the display apparatus 100 according to one embodiment of the present disclosure may prevent the light emitted from each subpixel SP from being emitted to the adjacent subpixel SP due to the color filters overlapped with each other at the boundary portion of the subpixels SP, thereby preventing color mixture between the subpixels SP from occurring.

Referring again back to FIG. 5, the pixel electrode 114 of the subpixel SP may be formed on the overcoat layer 113. The pixel electrode 114 may be connected to a drain electrode or a source electrode of the thin film transistor 112 through a contact hole passing through the overcoat layer 113 and the passivation layer 111c. The one edge portion of the pixel electrode 114 may be covered by the bank 115. The pixel electrode 114 may be made of at least one of a transparent metal material or a semi-transmissive metal material.

Because the display apparatus 100 according to an embodiment of the present disclosure is configured as the bottom emission type, the pixel electrode 114 may be formed of a transparent conductive material (or TCO), such as indium tin oxide (ITO) or indium zinc oxide (IZO) capable of transmitting light, or a semi-transmissive conductive material such as magnesium (Mg), silver (Ag), or an alloy of Mg and Ag.

Meanwhile, the material constituting the pixel electrode 114 may include MoTi. The pixel electrode 114 may be a first electrode or an anode electrode.

The bank 115 may be an area, which does not emit light, and disposed on one side of the light emission area EA of each of the plurality of sub-pixels SP. For example, the bank 115 may be disposed in the non-light emission area NEA where the circuit area CA is disposed. As shown in FIG. 5, the bank 115 may be formed to cover a portion where one edge of the pixel electrode 114 in each of the sub-pixels SP is connected to the thin film transistor 112. That is, the bank 115 may partially cover the pixel electrode 114. Accordingly, the bank 115 may prevent the pixel electrode 114 and reflective electrode 117 from contacting in the circuit area CA. The exposed portion of the pixel electrode 114 that is not covered by the bank 115 may be included in the light emitting portion (or light emission area EA).

As described above, the bank 115 is disposed in the non-light emission area NEA in which the circuit area CA is disposed, so that the non-light emission area NEA on the left and the non-light emission area NEA on the right may be asymmetrically provided with respect to the light emission area EA of FIG. 5. For example, based on the light emission area EA of FIG. 5, the left non-light emission area NEA may be provided as a structure including the thin film transistor 112 and the bank 115, and the right non-light emission area NEA may be provided as a structure without the bank 115 on the pattern portion 120.

After the bank 115 is formed, an organic light emitting layer 116 may be formed to cover the pixel electrodes 114 and the bank 115. Thus, the bank 115 may be provided between the pixel electrodes 114 and the organic light emitting layer 116. The bank 115 may be expressed in terms of a pixel-defining membrane. The bank 115 according to one example may comprise organic material and/or inorganic material. The banks 115 according to one example may be concave or inclined along the profile of the pattern portion 120.

Referring again back to FIG. 5, the organic light emitting layer 116 may be formed on the pixel electrodes 114 and the bank 115. According to one example, the organic light emitting layer 116 may be disposed in the light emission area EA and the non-light emission area NEA. The organic light emitting layer 116 may be provided between the pixel electrode 114 and the reflective electrode 117. Thus, when a voltage is applied to each of the pixel electrode 114 and the reflective electrode 117, an electric field is formed between the pixel electrode 114 and the reflective electrode 117. Therefore, the organic light emitting layer 116 may emit light. The organic light emitting layer 116 may be formed of a plurality of subpixels SP and a common layer provided on the bank 115.

The organic light emitting layer 116 according to an embodiment may be provided to emit white light. The organic light emitting layer 116 may include a plurality of stacks which emit lights of different colors. For example, the organic light emitting layer 116 may include a first stack, a second stack, and a charge generating layer (CGL) provided between the first stack and the second stack. The light emitting layer may be provided to emit the white light, and thus, each of the plurality of subpixels SP may include a color filter CF suitable for a corresponding color.

The first stack may be provided on the pixel electrode 114 and may be implemented a structure where a hole injection layer (HIL), a hole transport layer (HTL), a blue emission layer (EML(B)), and an electron transport layer (ETL) are sequentially stacked.

The charge generating layer may supply an electric charge to the first stack and the second stack. The charge generating layer may include an N-type charge generating layer for supplying an electron to the first stack and a P-type charge generating layer for supplying a hole to the second stack. The N-type charge generating layer may include a metal material as a dopant.

The second stack may be provided on the first stack and may be implemented in a structure where a hole transport layer (HTL), a yellow-green (YG) emission layer (EML(YG)), and an electron injection layer (EIL) are sequentially stacked.

In the display apparatus 100 according to an embodiment of the present disclosure, because the organic light emitting layer 116 is provided as a common layer, the first stack, the charge generating layer, and the second stack may be arranged all over the plurality of subpixels SP. The organic light emitting layer 116, according to another example, may be provided in a three-stacked structure or a four-stacked structure, depending on the number of stacks stacked.

The reflective electrode 117 may be formed on the organic light emitting layer 116. The reflective electrodes 117 may be disposed in the light emission area EA and the non-light emission area NEA. The reflective electrode 117 according to one example may include a metal material. The reflective electrode 117 may reflect the light emitted from the organic light emitting layer 116 in the plurality of subpixels SP toward the lower surface of the substrate 110. Therefore, the display apparatus 100 according to one embodiment of the present disclosure may be implemented as a bottom emission type display apparatus.

The display apparatus 100 according to one embodiment of the present disclosure is a bottom emission type and has to reflect light emitted from the light emitting layer 116 toward the substrate 110, and thus the reflective electrode 117 may be made of a metal material having high reflectance. The reflective electrode 117 according to one example may be formed of a metal material having high reflectance such as a stacked structure (Ti/Al/Ti) of aluminum and titanium, a stacked structure (ITO/Al/ITO) of aluminum and ITO, an Ag alloy and a stacked structure (ITO/Ag alloy/ITO) of Ag alloy and ITO. The Ag alloy may be an alloy such as silver (Ag), palladium (Pd) and copper (Cu). The reflective electrode 117 may be expressed as terms such as a second electrode, a cathode electrode and a counter electrode.

On the other hand, in the display apparatus 100 according to one embodiment of the present disclosure, the reflective portion 130 may be a part of the reflective electrode 117. Thus, the reflective portion 130 may reflect light, which is directed toward the adjacent sub-pixel SP, toward the light emission area EA of the emitting sub-pixel SP. The reflective portion 130 is a portion of the reflective electrode 117, and may be denoted by the drawing symbol 117a, as shown in FIG. 3. The reflective portion 130 may refer to a reflective electrode 117 that overlaps the pattern portion 120. In one example, the reflective portion 130 may include a reflective electrode 117a that is inclined while overlaps the pattern portion 120 and a reflective electrode 117a that is flat while overlaps the pattern portion 120.

The inclined reflective electrode 117a may include the first inclined reflective portion 131 and the second inclined reflective portion 133. The flat reflective electrode 117a may include a first flat reflective portion 132 and a second flat reflective portion 134. As a result, the reflective portion 130 disposed on the pattern portion 120 may include the first inclined reflective portion 131, the first flat reflective portion 132, the second inclined reflective portion 133, and the second flat reflective portion 134.

The first inclined reflective portion 131 according to one example may be disposed on the first inclined pattern portion 120s1. The entire first inclined reflective portion 131 may be disposed on the first inclined pattern portion 120s1, but is not limited thereto, and a portion of the first inclined reflective portion 131 may be disposed on the first inclined pattern portion 120s1 and the other portion may be disposed on the first flat pattern portion 120b1. This is because the first inclined reflective portion 131 is shifted with respect to the first inclined pattern portion 120s1 by a thickness of the organic light emitting layer 116. The first inclined pattern portion 120s1 may be provided with a horizontal length $L_1$ from a point where the first flat pattern portion 120b1 and the first inclined pattern portion 120s1 contact to an end of the light emission area EA. The horizontal length $L_1$ of the first inclined pattern portion 120s1 may be derived by the first thickness D1 of the first overcoat layer and the first angle $\theta_1$.

The first flat reflective portion 132, according to one example, is connected to the first inclined reflective portion 131 and may be disposed on the first flat pattern portion 120b1. The entire first flat reflective portion 132 may be disposed on the first flat pattern portion 120b1, but is not limited thereto, and a portion of the first flat reflective portion 132 may be disposed on the first flat pattern portion 120b1 and the other portion of the first flat reflective portion 132 may be disposed on the second inclined pattern portion 120s2. This is because the first flat reflective portion 132 is shifted with respect to the first flat pattern portion 120b1 by a thickness of the organic light emitting layer 116. The first flat pattern portion 120b1 may have a horizontal length $L_F$ from a point where the first flat pattern portion 120b1 and the first inclined pattern portion 120s1 contact to a point where the first flat pattern portion 120b1 and the second inclined pattern portion 120s2 contact.

The second inclined reflective portion 133, according to one example, is connected to the first flat reflective portion 132 and may be disposed on the second inclined pattern portion 120s2. The entire second inclined reflective portion 133 may be disposed on the second inclined pattern portion 120s2, but is not limited thereto, and a portion of the second inclined reflective portion 133 may be disposed on the second inclined pattern portion 120s2 and the other portion of the second inclined reflective portion 133 may be disposed on the second flat pattern portion 120b2. This is because the second inclined reflective portion 133 is shifted with respect to the second inclined pattern portion 120s2 by a thickness of the organic light emitting layer 116. The second inclined pattern portion 120s2 may be provided with a horizontal length $L_2$ from a point where the first flat pattern portion 120b1 and the second inclined pattern portion 120s2 contact to a point where the second flat pattern portion 120b2 and the second inclined pattern portion 120s2 contact. The horizontal length $L_2$ of the second inclined pattern portion 120s2 may be derived by the second thickness D2 of the second overcoat layer and the second angle $\theta_2$.

Here, the overall horizontal length from the point where the second flat pattern portion 120b2 and the second inclined pattern portion 120s2 contact to the end of the light emission area EA may be $L_T$. The overall horizontal length $L_T$ may be the sum of the horizontal length $L_1$ of the first inclined pattern portion 120s1 and the horizontal length $L_F$ of the first flat pattern portion 120b1 and the horizontal length $L_2$ of the second inclined pattern portion 120s2.

The second flat reflective portion 134, according to one example, is connected to the second inclined reflective portion 133 and may be disposed on the second flat pattern portion 120b2. The entire second flat reflective portion 134 may be disposed on the second flat pattern portion 120b2. This is because the second flat reflective portion 134 is formed with a narrower width than the second flat pattern portion 120b2 by the thickness of the organic light emitting layer 116.

Thus, the display apparatus 100 according to one embodiment of the present disclosure includes the first inclined reflective portion 131 disposed at the first angle $\theta_1$ with respect to the first extension line EXL1, and the second inclined reflective portion 133 disposed at the second angle $\theta_2$ with respect to the second extension line EXL2, and the first inclined reflective portion 131 and the second inclined reflective portion 133 may reflect light directed toward an adjacent sub-pixel SP and/or light that is extinguished by being total reflected from the interfaces, to a light emission area EA and/or the non-light emission area NEA of the emitting sub-pixel SP.

The encapsulation layer 118 is formed on the reflective electrode 117. The encapsulation layer 118 serves to prevent oxygen or moisture from being permeated into the organic light emitting layer 116 and the reflective electrode 117. To this end, the encapsulation layer 118 may include at least one inorganic film and at least one organic film.

Meanwhile, as shown in FIG. 3, the encapsulation layer 118 may be disposed not only in the light emission area EA but also in the non-light emission area NEA. The encapsulation layer 118 may be disposed between the reflective electrode 117 and an opposing substrate 200.

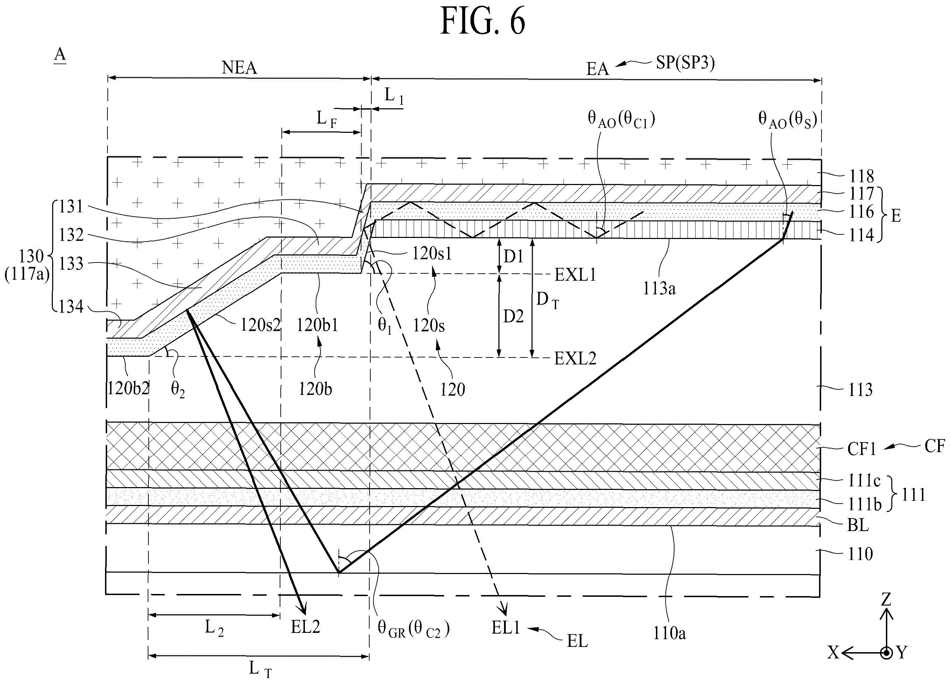

Hereinafter, with reference to FIG. 6, the first angle $\theta_1$ and the second angle $\theta_2$ at which the first inclined pattern portion 120s1 (or first inclined reflective portion 131) and the second inclined pattern portion 120s2 (or the second inclined reflective portion 133), respectively, of the display apparatus 100 according to one embodiment of the present disclosure are disposed will be described in detail by associating mathematical expressions.

FIG. 6 is a schematic enlarged cross-sectional view of portion A shown in FIG. 3.

Referring to FIG. 6, the first angle $\theta_1$ and the second angle $\theta_2$ may be optimized angles by mathematical expressions regarding the critical angle (or total reflection angle) between the pixel electrode 114 and the overcoat layer 113, the refractive index of the pixel electrode 114, the refractive index of the overcoat layer 113, and the refractive index of the outside air. The $\theta_{AO}$ shown in FIG. 6 may be an incidence angle at which light emitted by the organic light emitting layer 116 is incident on the interface between the pixel electrode 114 and the overcoat layer 113. $\theta_{GR}$ may be an incidence angle at which light emitted by the organic light emitting layer 116 is incident into an interface between the substrate 110 and the outside air adjacent to the substrate 110. $\theta_{C2}$ may be an angle at which light emitted by the organic light emitting layer 116 is totally reflected at the interface between the substrate 110, and the outside air adjacent to the substrate 110. That is, $\theta_{C2}$ may be a critical angle at the interface between the substrate 110 and the outside air.

In one example, the first angle $\theta_1$ may be provided to satisfy a mathematical expression below (Equation 1),

$$\theta_1 > 90° - \theta_{c1}$$

$\theta_{C1}$ may denote an angle at which a portion of the light emitted by the organic light emitting layer 116 is totally reflected between the pixel electrode 114 and the overcoat layer 113. That is, $\theta_{C1}$ may denote a critical angle between the pixel electrode 114 and the overcoat layer 113. For example, $\theta_{C1}$ may be less than 90°.

On the other hand, in Equation 1 above, the angle $\theta_{C1}$ at which a portion of the light emitted by the organic light emitting layer 116 is totally reflected between the pixel electrode 114 and the overcoat layer 113 may be provided to satisfy the mathematical expression below (or Equation 2),

$$\theta_{c1} = \arcsin(\frac{n_{oc}}{n_{Anode}})$$

$n_{oc}$ may denote a refractive index of the overcoat layer 113, and $n_{Anode}$ may denote a refractive index of the pixel electrode 114. On the other hand, when the refractive index of the pixel electrode 114 is greater than the refractive index of the overcoat layer 113, light having an angle of emission greater than $\theta_{C1}$ (e.g., greater than 90°) may be extinguished inside the substrate by the wave guide. Here, the light emission angle may refer to an angle at which light emitted by the organic light emitting layer 116 is incident on the interface between the overcoat layer 113 and the pixel electrode 114. Thus, $\theta_{C1}$ may be provided to be less than 90°. According to Equation 1 above, if $\theta_{C1}$ is greater than 90°, the first angle $\theta_1$ has a zero or negative value, so that the first inclined pattern portion 120s1 cannot be formed. Therefore, the display apparatus 100 according to one embodiment of the present disclosure is provided such that when the refractive index of the pixel electrode 114 is greater than the refractive index of the overcoat layer 113, light emitted from the organic light emitting layer 116 is incident to the interface between the overcoat layer 113 and the pixel electrode 114 at an angle equal to or less than $\theta_{C1}$ (or less than 90°), then the light may be reflected from the first inclined reflective portion 131 formed at the first angle $\theta_1$ satisfying Equations 1 and 2 above and be directing to the outside of the substrate 110.

On the other hand, in a case where a portion of the light emitted by the organic light emitting layer 116 is not directed to the outside of the substrate but trapped inside the substrate 110, the angle $\theta_s$ of a portion of the light incident on the interface between the pixel electrode 114 and the overcoat layer 113 is provided to satisfy the mathematical expression (or Equation 3) as shown below,

$$270° - 2\theta_1 - \theta_{c1} > \theta_S$$

$\theta_1$ may denote the first angle, and $\theta_{C1}$ may be an angle at which a portion of the light emitted by the organic light emitting layer 116 is totally reflected between the pixel electrode 114 and the overcoat layer 113.

In the display apparatus 100 according to one embodiment of the present disclosure, the first angle $\theta_1$ may be provided to satisfy a mathematical expression below(or Equation 4),

$$\theta_1 < 135° - 0.5\arcsin(\frac{n_{oc}}{n_{Anode}}) - 0.5\arcsin(\frac{n_{oc}}{n_{Anode}}\sin(\arcsin(\frac{1}{n_{oc}})))$$

$n_{oc}$ may be a refractive index of the overcoat layer 113, and $n_{Anode}$ may be a refractive index of the pixel electrode 114.

Thus, in the display apparatus 100 according to one embodiment of the present disclosure, the first angle $\theta_1$ may be provided to satisfy the above equations 1 and 4, which may be represented by a following mathematical expression (or Equation 5).

$$90° - \theta_{c1} < \theta_1 < 135° - 0.5\arcsin(\frac{n_{oc}}{n_{Anode}}) - 0.5\arcsin(\frac{n_{oc}}{n_{Anode}}\sin(\arcsin(\frac{1}{n_{oc}})))$$

In the display apparatus 100 according to one embodiment of the present disclosure, the second angle $\theta_2$ may be provided to satisfy a mathematical expression (or Equation 6) such as the following,

$$\theta_2 < \arcsin(\frac{n_{air}}{n_{oc}})$$

$n_{oc}$ may denote a refractive index of the overcoat layer 113, and $n_{air}$ may denote a refractive index of the outside air adjacent to the substrate 110 (or a lower surface of the substrate 110).

As a result, in the display apparatus 100 according to one embodiment of the present disclosure, the refractive index of the pixel electrode 114, the refractive index of the overcoat layer 113, the critical angle (or total reflection angle) between the pixel electrode 114 and the overcoat layer 113, and the refractive index of the outside air may be provided to satisfy Equation 1 to Equation 6, as shown in FIG. 6, thus light directed toward the adjacent sub-pixel (or light that is extinguished by the wave guide and light that is totally reflected and extinguished inside the substrate) may be reflected from the reflective portion 130 and directed to the light emission area EA or the non-light emission area NEA of the sub-pixel in the form of a first reflected light EL1 or a second reflected light EL2, thereby improving the light extraction efficiency.

Furthermore, in the display apparatus 100 according to one embodiment of the present disclosure, the first angle $\theta_1$ at which the first inclined pattern portion 120s1 (or the first inclined reflective portion 131) is disposed, and the second angle $\theta_2$ at which the second inclined pattern portion 120s2 (or the second inclined reflective portion 133) is disposed, may be provided to be optimal angles according to the above equations 1 to 6, thereby maximizing the reflection efficiency of the reflective portion 130. For example, the light extraction efficiency of the first reflected light EL1 by the first inclined reflective portion 131 and the light extraction efficiency of the second reflected light EL2 by the second inclined reflective portion 133 may be maximized, thereby maximizing the light extraction efficiency.

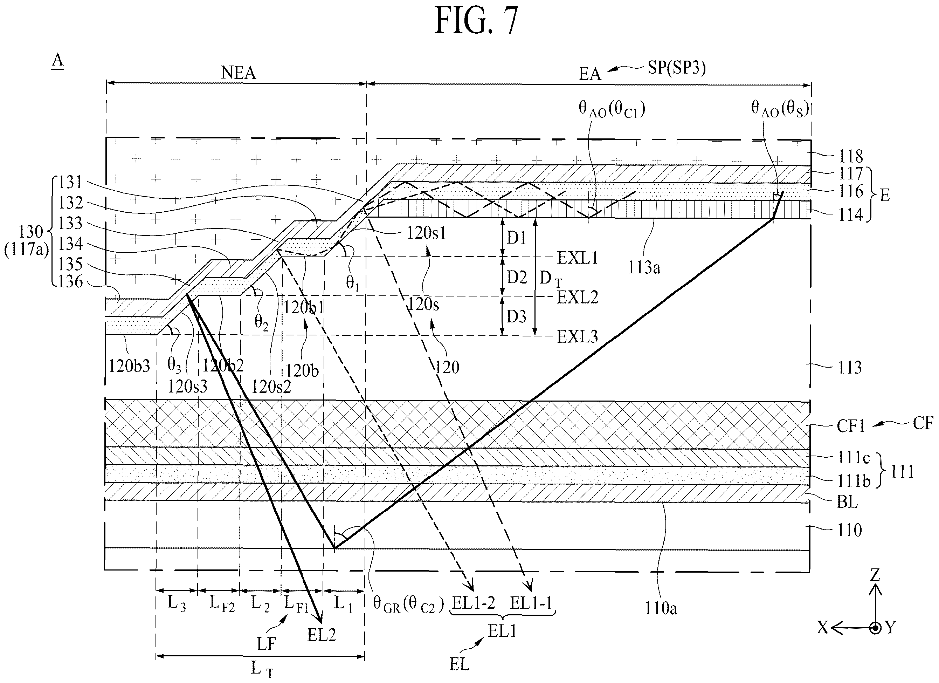

FIG. 7 is a schematic enlarged cross-sectional view illustrating a display apparatus according to another embodiment of the present disclosure, as another example of the portion A shown in FIG. 3.

Referring to FIG. 7, the display apparatus 100 according to another embodiment of the present disclosure is identical to the display apparatus according to FIG. 1 described above, except that the structure of the pattern portion 120 and the reflective portion 130 has been changed. Therefore, the same drawing symbols have been assigned to the same configuration, and only the different configurations will be described hereinafter.

In the case of the display apparatus according to FIG. 1, the inclined surface 120s of the pattern portion 120 is provided to include the first inclined pattern portion 120s1 disposed at the first angle $\theta_1$ with respect to the upper surface 110a of the substrate 110 and the second inclined pattern portion 120s2 disposed at the second angle $\theta_2$, thus the reflective portion 130 may include the first inclined reflective portion 131 disposed at the first angle $\theta_1$ and the second inclined reflective portion 133 disposed at the second angle $\theta_2$. Accordingly, in the case of the display apparatus according to FIG. 1, the first inclined reflective portion 131 and the second inclined reflective portion 133 provided at multiple angles (or the same angle), i.e., the inclined reflective portion provided in two stages, enable the light that is extinguished by the wave guide and the light that is totally reflected and extinguished inside the substrate, to be output to the outside in the form of the first reflected light EL1 and the second reflected light EL2, thereby improving light extraction efficiency.

In contrast, in the case of the display apparatus according to FIG. 7, the pattern portion 120 may further include a third inclined pattern portion 120s3 and a third flat pattern portion 120b3. The third inclined pattern portion 120s3 according to an example may be disposed between the second inclined pattern portion 120s2 and the substrate 110 and may be disposed at a third angle $\theta_3$ with respect to the upper surface 110a of the substrate 110. Here, the third angle $\theta_3$ may be equal to or different from the second angle $\theta_2$. As shown in FIG. 7, a third extension line EXL3 is disposed parallel to the upper surface 110a of the substrate 110, so the third inclined pattern portion 120s3 may be represented as being disposed at the third angle $\theta_3$ with respect to the third extension line EXL3. The third extension line EXL3 may refer to an imaginary line extending in the first direction (X-axis direction) from a point where the third inclined pattern portion 120s3 and the third flat pattern portion 120b3 contact. The third flat pattern portion 120b3 according to an example may be disposed spaced apart from the second flat pattern portion 120b2 and may be connected to the third inclined pattern portion 120s3. Accordingly, as shown in FIG. 7, the display apparatus 100 according to another embodiment of the present disclosure may be provided with the inclined pattern portions 120s in three stages.

On the other hand, since the display apparatus 100 according to another embodiment of the present disclosure includes the pattern portion 120 in three stages, the reflective portion 130 disposed on the pattern portion 120 may also be provided in three stages. The reflective portion 130 according to one example may include the first inclined reflective portion 131, the first flat reflective portion 132, the second inclined reflective portion 133, the second flat reflective portion 134, the third inclined reflective portion 135, and the third flat reflective portion 136. The first inclined reflective portion 131 may be disposed on the first inclined pattern portion 120s1. The first flat reflective portion 132 may be connected to the first inclined reflective portion 131 and may be disposed on the first flat pattern portion 120b1. The second inclined reflective portion 133 is connected with the first flat reflective portion 132 and may be disposed on the second inclined pattern portion 120s2. The second flat reflective portion 134 is connected to the second inclined reflective portion 133 and may be disposed on the second flat pattern portion 120b2. The third inclined reflective portion 135 is connected to the second flat reflective portion 134 and may be disposed on the third inclined pattern portion 120s3. The third flat reflective portion 136 is connected to the third inclined reflective portion 135 and may be disposed on the third flat pattern portion 120b3.

Thus, in the display apparatus 100 according to another embodiment of the present disclosure, the inclined surface 120s of the pattern portion 120 is provided to include the first inclined pattern portion 120s1, the second inclined pattern portion 120s2, and the third inclined pattern portion 120s3. Here, the first inclined pattern portion 120s1 is provided at the first angle $\theta_1$ with respect to the upper surface 110a of the substrate 110, and the second inclined pattern portion 120s2 is provided at the second angle $\theta_2$, and the third inclined pattern portion 120s3 is provided at a third angle $\theta_3$. Thus, the reflective portion 130 may include the first inclined reflective portion 131 provided at the first angle $\theta_1$, the second inclined reflective portion 133 provided at the second angle $\theta_2$, and the third inclined reflective portion 135 provided at the third angle $\theta_3$. Accordingly, the display apparatus 100 according to another embodiment of the present disclosure may include the first inclined reflective portion 131, the second inclined reflective portion 133 and the third inclined reflective portion 135 provided at multiple angles, i.e., the inclined reflective portion provided in three stages enables light that is extinguished by the wave guide and light that is totally reflected and extinguished inside the substrate 110, to be output to the outside in the form of the first reflected light EL1 and the second reflected light EL2, thereby improving light extraction efficiency.

On the other hand, the display apparatus 100 according to another embodiment of the present disclosure may be provided such that the pattern portion 120 further includes a third inclined pattern portion 120s3, such that the overall horizontal length $L_T$ may be increased by a horizontal length of the third inclined pattern portion 120s3. For example, the overall horizontal length $L_T$ may be a horizontal length of half of the pattern portion 120, and may be the sum of the horizontal length $L_1$ of the first inclined pattern portion 120s1, the horizontal length $L_{F1}$ of the first flat pattern portion 120b1 and the horizontal length $L_2$ of the second inclined pattern portion 120s2, the horizontal length $L_{F2}$ of the second flat pattern portion 120b2, and the horizontal length $L_3$ of the third inclined pattern portion 120s3. The horizontal length $L_{F2}$ of the second flat pattern portion 120b2 may be a horizontal length from a point where the second flat pattern portion 120b2 and the second inclined pattern portion 120s2 contact to a point where the second flat pattern portion 120b2 and the third inclined pattern portion 120s3 contact. The horizontal length $L_3$ of the third inclined pattern portion 120s3 may be a horizontal length from a point where the second flat pattern portion 120b2 and the third inclined pattern portion 120s3 contact to a point where the third flat pattern portion 120b3 and the third inclined pattern portion 120s3 contact.

Thus, in the display apparatus 100 in accordance with other embodiments of the present disclosure, the first reflective light EL1 may include a first sub-reflective light EL1-1 reflected from the first inclined reflective portion 131 and directed to the outside of the substrate 110, and a second sub-reflective light EL1-2 reflected from the second inclined reflective portion 133 and directed to the outside of the substrate 110. Although not shown, the first reflective light EL1 may further include a third sub-reflective light reflected from the third inclined reflective portion 135 and directed to the outside of the substrate 110. The second reflected light EL2 may be reflected from the third inclined reflective portion 135 and directed to the outside of the substrate 110. However, and not necessarily limited thereto, the second reflected light EL2 may be reflected from the first inclined reflective portion 131 or the second inclined reflective portion 133 and directed to the outside of the substrate 110.

Meanwhile, in the display apparatus 100 according to another embodiment of the present disclosure, the overcoat layer 113 (or the third overcoat layer) on which the third inclined pattern portion 120s3 is formed may be provided to have a third thickness D3. The overcoat layer 113 (or second overcoat layer) on which the second inclined pattern portion 120s2 is formed may be provided to have the second thickness D2. The overcoat layer 113 (or the first overcoat layer) in which the first inclined pattern portion 120s1 is formed may be provided to have the first thickness D1. As shown in FIG. 7, the third thickness D3 may be provided to be equal to the first thickness D1 (or the second thickness D2), but is not necessarily limited thereto, and the third thickness D3 may be provided to be thicker or thinner than the second thickness D2 depending on the optimal design for light extraction efficiency. The sum of the first thickness D1, the second thickness D2 and the third thickness D3 may be the total thickness $D_T$ of the overcoat layer 113 on which the first inclined pattern portion 120s1, the second inclined pattern portion 120s2 and the third inclined pattern portion 120s3 are disposed.

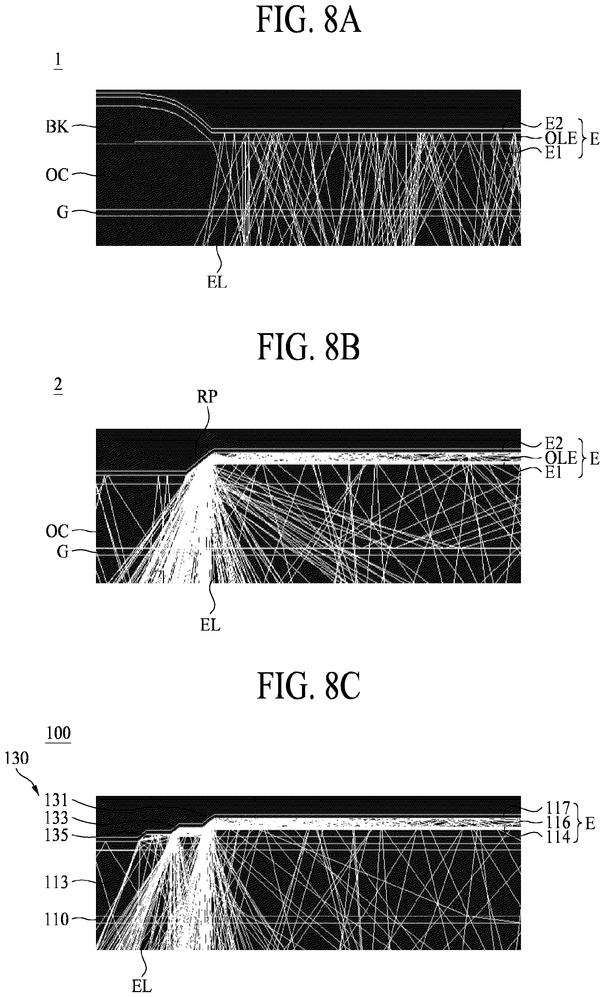

FIG. 8A is an image illustrating light extraction characteristics of a display apparatus according to a comparative example, FIG. 8B is an image illustrating light extraction characteristics of a display apparatus according to another comparative example, and FIG. 8C is an image illustrating light extraction characteristics of a display apparatus according to another embodiment of the present disclosure.

FIG. 8a is an illustration of light extraction characteristics of the display apparatus 1 according to a comparative example, in which the overcoat layer OC has a structure without an inclined surface. Specifically, in the display apparatus 1 according to the comparative example of FIG. 8a, the light emitting element layer E may include a first electrode E1, an organic light emitting layer (OLE) on the first electrode E1, and a second electrode E2 on the organic light emitting layer OLE. The bank BK covers an edge of the first electrode E1, and the organic light emitting layer OLE and the second electrode E2 may be formed on the first electrode E1 and the bank BK. Since the display apparatus 1 according to the comparative example of FIG. 8a has a structure in which the overcoat layer OC has no inclined surface, light emitted from the organic light emitting layer OLE may be reflected from the second electrode E2 and directed to the lower surface of the substrate G in the form of reflected light EL.

FIG. 8B illustrates the light extraction characteristics of the display apparatus 2 according to another comparative example, in which the overcoat layer OC has a single inclined surface. Specifically, in the display apparatus 2 according to the other comparative example of FIG. 8B, the light emitting element layer E may include a first electrode E1, an organic light emitting layer (OLE) on the first electrode E1, and a second electrode E2 on the organic light emitting layer (OLE). The organic light emitting layer OLE and the second electrode E2 may be formed entirely on the overcoat layer OC along a profile of the overcoat layer OC having the single inclined surface. Since the display apparatus 2 according to the other comparative example of FIG. 8B is a structure having a single inclined surface on the overcoat layer OC without banks, a reflective surface RP that is part of the second electrode E2 may be formed on the single inclined surface. Therefore, in the display apparatus 2 according to the other comparative example of FIG. 8B, light emitted by the organic light emitting layer OLE may be reflected from the second electrode E2 and directed to the lower surface of the substrate G, or may be reflected from the reflective surface RP and directed in the form of reflected light EL.

Referring to FIGS. 8A and 8B, it may be seen that the light extraction efficiency of the display apparatus 2 according to the other comparative example of FIG. 8B is higher compared to the light extraction efficiency of the display apparatus 1 according to the comparative example of FIG. 8A. This is because the reflective surface RP reflects the light emitted from the organic light emitting layer OLE and directed to the adjacent sub-pixels, and thus, light extraction efficiency may be higher.

FIG. 8C illustrates light extraction characteristics of the display apparatus 100 according to another embodiment of the present disclosure, wherein the overcoat layer OC has a structure with three inclined surfaces. As described above, the display apparatus 100 according to another embodiment of the present specification is provided with the first inclined reflective portion 131, the second inclined reflective portion 133, and the third inclined reflective portion 135, such that the reflected light EL includes reflected light that is reflected from the first inclined reflective portion 131 and directed to a lower portion of the substrate 110, reflected light that is reflected from the second inclined reflective portion 133 and directed to a lower portion of the substrate 110, and reflected light that is reflected from the third inclined reflective portion 135 and directed to a lower portion of the substrate 110. Thus, it may be seen that the display apparatus 100 according to other embodiments of the present disclosure has a higher light extraction efficiency compared to the display apparatus according to the comparative example of FIG. 8A and/or FIG. 8B.

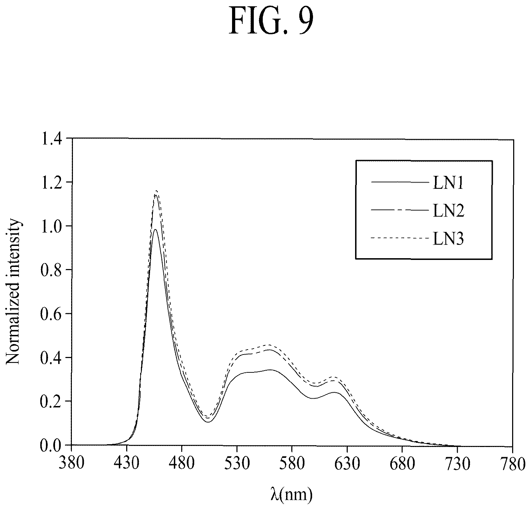

FIG. 9 is a graph depicting light intensity as a function of wavelength for a display apparatus according to another embodiment of the present disclosure compared to a display apparatus according to a comparative example.

Referring to FIG. 9, the horizontal axis indicates a wavelength $\lambda$, and the perpendicular axis indicates a light intensity. LN1 is a graph indicating a light intensity according to a wavelength of the display apparatus 1 according to the comparative example of FIG. 8a. In other words, LN1 is a graph indicating a light intensity according to a wavelength of the display apparatus without an inclined surface in the overcoat layer OC. LN2 is a graph showing the light intensity according to a wavelength of the display apparatus 2 according to another comparative example of FIG. 8b. That is, LN2 is a graph representing the light intensity as a function of wavelength of a display apparatus having a single inclined surface in the overcoat layer OC. LN3 is a graph representing the light intensity according to a wavelength of the display apparatus 100 according to another embodiment of the present disclosure in FIG. 8C. That is, LN3 is a graph representing the light intensity as a function of wavelength of a display apparatus having three inclined surfaces in the overcoat layer OC.

As shown in Figure 9, it may be seen that LN3 has the highest light intensity at all wavelengths compared to LN1 and LN2. For example, it may be seen that at a blue wavelength of about 460 nm, LN1 has a light intensity of about 0.98, while LN3 has a light intensity of 1.18. Thus, the display apparatus 100 according to another embodiment of the present disclosure may have an improved light intensity of about 17% compared to the display apparatus 1 according to the comparative example at a wavelength of about 460 nm. By contrasting the areas under each of the graphs of LN1 and LN3, it may be seen that LN3 has an improved light intensity of about 27% compared to LN1. Thus, the display apparatus 100 according to another embodiment of the present disclosure is provided to have three inclined surfaces in the overcoat layer thereby having about 27% more improved light extraction efficiency compared to the display apparatus 1 having no inclined surfaces in the overcoat layer.

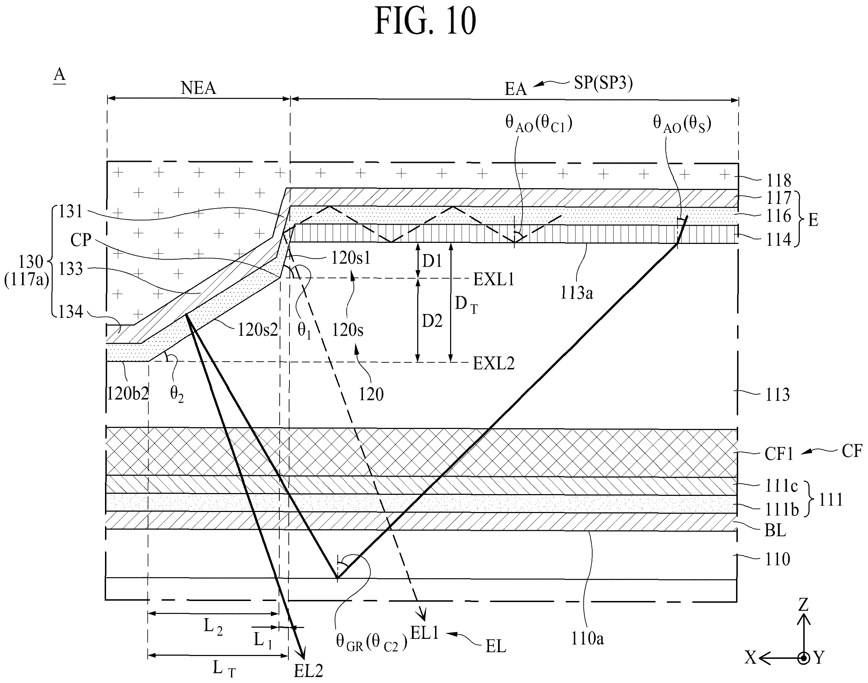

FIG. 10 is a schematic enlarged cross-sectional view illustrating a display apparatus according to another embodiment of the present disclosure, as another example of the portion A shown in FIG. 3.

Referring now to FIG. 10, the display apparatus 100 according to another embodiment of the present disclosure is identical to the display apparatus according to FIG. 1 described above, except that the structure of the pattern portion 120 and the reflective portion 130 has been changed. Therefore, the same drawing symbols have been assigned to the same configuration, and only the different configurations will be described hereinafter.

In the case of the display apparatus according to FIG. 1 described above, the inclined surface 120s of the pattern portion 120 is provided to include the first inclined pattern portion 120s1 and the second inclined pattern portion 120s2. Here, the first inclined pattern portion 120s1 is provided at the first angle $\theta_1$ with respect to the upper surface 110a of the substrate 110, and the second inclined pattern portion 120s2 is provided at the second angle $\theta_2$ spaced in the first direction (X-axis direction) from the first inclined pattern portion 120s1. Thus, the reflective portion 130 may include the first inclined reflective portion 131 and the second inclined reflective portion 133, the first inclined reflective portion 131 is provided at the first angle $\theta_1$, and the second inclined reflective portion 133 is spaced in the first direction (X-axis direction) from the first inclined reflective portion 131 and provided at the second angle $\theta_2$. Here, the first inclined pattern portion 120s1 may be connected with the second inclined pattern portion 120s2 via the first flat pattern portion 120b1. Accordingly, in the case of the display apparatus according to FIG. 1, the first inclined reflective portion 131 and the second inclined reflective portion 133, which are provided at multiple angles (or equal angles), i.e., the inclined reflective portion provided in two stages enable light that is extinguished by the wave guide and light that is totally reflected and extinguished inside the substrate, to be output to the outside in the form of the first reflected light EL1 and the second reflected light EL2, thereby improving light extraction efficiency.

In contrast, in the display apparatus according to FIG. 10, the first angle $\theta_1$ and the second angle $\theta_2$ are different, and the first inclined pattern portion 120s1 may be directly connected with the second inclined pattern portion 120s2. In other words, the display apparatus according to FIG. 10 may be provided with a structure in which the first angle $\theta_1$ and the second angle $\theta_2$ are different from the display apparatus according to FIG. 1, and the first flat pattern portion 120b1 connecting the first inclined pattern portion 120s1 and the second inclined pattern portion 120s2 is deleted (or omitted). When the first angle $\theta_1$ and the second angle $\theta_2$ are the same, the first inclined pattern portion 120s1 and the second inclined pattern portion 120s2 are provided as a single inclined surface without a bent, thus one of the light that is extinguished by the wave guide and the light that is totally reflected and extinguished in the interior of the substrate 110 may not be extracted to the exterior of the substrate 110 through the first inclined reflective portion 131 disposed on the first inclined pattern portion 120s1 and the second inclined reflective portion 133 disposed on the second inclined pattern portion 120s2.

Thus, in the case of the display apparatus 100 according to FIG. 10, since the first angle $\theta_1$ and the second angle $\theta_2$ are different, the first inclined reflective portion 131 disposed on the first inclined pattern portion 120s1 and the second inclined reflective portion 133 disposed on the second inclined pattern portion 120s2 may be disposed at different angles with respect to the upper surface 110a of the substrate 110, as a result, both the light that is extinguished by the wave guide and the light that is totally reflected and extinguished from the interior of the substrate 110 may be extracted to the exterior of the substrate 110 through the first inclined reflective portion 131 and the second inclined reflective portion 133, thereby improving light extraction efficiency.

On the other hand, as shown in FIG. 10, the first angle $\theta_1$ may be larger than the second angle $\theta_2$. However, without being limited thereto, the first angle $\theta_1$ may be provided to be smaller than the second angle $\Theta z$ if both the light that is extinguished by the wave guide and the light that is totally reflected and extinguished from the interior of the substrate 110 may be extracted to the exterior of the substrate 110.

The display apparatus 100 according to FIG. 10 may further include a connection point CP connecting the first inclined pattern portion 120s1 and the second inclined pattern portion 120s2, since the first angle $\theta_1$ and the second angle $\Theta z$ are different. As shown in FIG. 10, the pattern portions 120 are formed in the non-light emission area NEA, therefore the connection points CP may be disposed in the non-light emission area NEA. The display apparatus 100 according to FIG.

10 may have a structural feature in which the first inclined pattern portion 120s1 is directly connected with the second inclined pattern portion 120s2 at the connection point CP, so that the second inclined reflective portion 133 disposed on the second inclined pattern portion 120s2 and the first inclined reflective portion 131 disposed on the first inclined pattern portion 120s1 are directly connected.

On the other hand, in the display apparatus 100 according to FIG. 10, since the first inclined pattern portion 120s1 is directly connected with the second inclined pattern portion 120s2 at the connection point CP, the overall horizontal length $L_T$ from the point where the second inclined pattern portion 120s2 and the second flat pattern portion 120b2 contact to the end of the light emission area EA may be further reduced compared to the display apparatus according to FIG. 1. For example, the overall horizontal length $L_T$ may be a length that is the sum of the horizontal length $L_1$ of the first inclined pattern portion 120s1 and the horizontal length $L_2$ of the second inclined pattern portion 120s2. Thus, the second inclined pattern portion 120s2 may be disposed closer to the light emission area EA in the horizontal direction (or the first direction (X-axis direction)).

By disposing the second inclined pattern portion 120s2 closer to the light emission area EA in the horizontal direction (or the first direction (X-axis direction)), the second inclined reflective portion 133 disposed on the second inclined pattern portion 120s2 may also be disposed closer to the light emission area EA. Thus, the display apparatus 100 according to another embodiment of the present disclosure may have the second inclined reflective portion 133 disposed closer to the light emission area EA, therefore the loss amount of light emitted by the organic light emitting layer 116 and reaching the second inclined reflective portion 133, is minimized. For example, while light emitted by the organic light emitting layer 116 passes through a plurality of layers (e.g., the overcoat layer 113, the color filter CF, the inorganic film layer 111) in the substrate to reach the second inclined reflective portion 133, the loss of the light may be occurred. However, the display apparatus 100 according to another embodiment of the present disclosure may be provided such that the second inclined reflective portion 133 is disposed close to the light emission area EA, such that the light loss to reach the second inclined reflective portion 133 may be minimized, thereby maximizing the light extraction efficiency of the substrate 110 to the outside.

In addition, the present disclosure has described a display apparatus 100 including the first inclined pattern portion 120s1 (or the first inclined reflective portion 131) having the first angle $\theta_1$, the second inclined pattern portion 120s2 (or the second inclined reflective portion 133) having the second angle $\theta_2$, and the third inclined pattern portion 120s3 (or the third inclined reflective portion 135) having a third angle $\theta_3$ have been described, but the number and optimal extent (or optimal horizontal length and optimal thickness) of the inclined pattern portions (or the inclined reflective portions) may be varied depending on the refractive index and design of the material. Here, the material may be meant to include at least one of the materials of the overcoat layer 113, the material of the organic light emitting layer 116, the material of the pixel electrode 114, the material of the reflective electrode 117 (or the reflective portion 130), and the material of the substrate 110.

The display apparatus according to the present disclosure is provided to have the reflective portion disposed on the pattern portion that is formed to be concave between the plurality of sub-pixels, so that light directed at the adjacent sub-pixels may be reflected from the reflective portion, thereby improving light extraction efficiency.

Since the display apparatus according to the present disclosure may have light extraction even in the non-light emission area through the reflective portion, it may have the same light extraction efficiency or even better light extraction efficiency with lower power compared to a display apparatus without the reflective portion, thereby reducing overall power consumption.

In the display apparatus according to the present disclosure, the inclined surface of the pattern portion is provided at multiple angles (the first angle and the second angle) with respect to the upper surface of the substrate, so that light extraction efficiency may be maximized as both the light that is extinguished by the wave guide and the light that is totally reflected and extinguished inside the substrate may be directed to the outside.

The effects to be obtained from the present disclosure are not limited to those mentioned above, and other effects not mentioned will be apparent to one of ordinary skill in the art from the description.

Embodiments of the present disclosure have been described in more detail with reference to the accompanying drawings, but the present disclosure is not necessarily limited to these embodiments and may be practiced in various modifications without departing from the technical ideas of the present disclosure. Accordingly, the embodiments disclosed herein are intended to illustrate, not limit, the technical ideas of the present disclosure, and the scope of the technical ideas of the present disclosure is not limited by these embodiments. Therefore, the embodiments described above are exemplary in all respects and should be understood as non-limiting. All technical ideas within the scope of protection of this specification shall be construed to be included within the scope of the claims of this specification.

**Claims**

1. A display apparatus comprising:

a substrate (110) including a non-light emission area (NEA) and a plurality of sub-pixels (SP) each having a light emission area (EA), the non-light emission area (NEA) surrounding the light emission areas (EA) of the plurality of sub-pixels (SP);

a pattern portion (120) disposed in the non-light emission area (NEA) between the plurality of the sub-pixels (SP), the pattern portion (120) being concave; and

a reflective portion (130) disposed on the pattern portion (120),

wherein the pattern portion (120) includes a plurality of inclined pattern portion comprising:

a first inclined pattern portion (120s1) disposed to have a first angle ($\theta_1$) with respect to the substrate (110); and

a second inclined pattern portion (120s2) disposed closer to the substrate (110) than the first inclined pattern portion (120s1) and having a second angle ($\theta_2$) with respect to the substrate (110).

2. The display apparatus of claim 1, wherein the first angle ($\theta_1$) is equal to or different from the second angle ($\theta_2$).

3. The display apparatus of claim 1 or 2, wherein the pattern portion (120) further includes at least one flat pattern portion (120b1) connecting two adjacent inclined pattern portions of the plurality of inclined pattern portions.

4. The display apparatus of claim 3, wherein the at least one flat pattern portion includes:

a first flat pattern portion (120b1) connecting the first inclined pattern portion (120s1) and the second inclined pattern portion (120s2); and/or

a second flat pattern portion (120b2) extending from the second inclined pattern portion (120s2).

5. The display apparatus according to any one of the preceding claims, wherein the reflective portion (130) has a shape corresponding to that of the pattern portion (120).

6. The display apparatus according to any one of the preceding claims, wherein a width of the pattern portion (120) decreases in a direction toward the substrate (110).

7. The display apparatus according to any one of the preceding claims, wherein each of the sub-pixels 8SP) includes a circuit area (CA) disposed in the non-light emission area (NEA) at one side of the light emission area (EA), and the pattern portion (120) surrounds the light emission area (EA) except for the one side of the light emission area (EA) on which the circuit area (CA) is disposed.

8. The display apparatus according to any one of the preceding claims, wherein the pattern portion (120) is formed by an overcoat layer (113) disposed on the substrate (110),

wherein each of the plurality of sub-pixels (SP) includes a pixel electrode (114) disposed on the overcoat layer (113), and

wherein the first inclined pattern portion (120s1) is disposed adjacent to the pixel electrode (114) and/or the second inclined pattern portion (120s2) is spaced apart from the pixel electrode (114).

9. The display apparatus of claim 8, wherein each of the plurality of sub-pixels further includes:

an organic light emitting layer (116) disposed on the pixel electrodes (114); and

a reflective electrode (117) on the organic light emitting layer (116), the reflective portion (130) being a portion of the reflective electrode (117).

10. The display apparatus of claim 9, wherein an angle $\theta_s$ of the portion of light incident on an interface between one of the pixel electrodes (114) and the overcoat layer (113) is provided to satisfy a mathematical expression below,

$$270° - 2\theta_1 - \theta_{c1} > \theta_S$$

Wherein the letter $\theta_1$ denotes the first angle, and the letter $\theta_{c1}$ denotes an angle at which a portion of light emitted by the organic light emitting layer (116) is totally reflected from the interface.

11. The display apparatus of claim 9 or 10, wherein the first angle $\theta_1$ is provided to satisfy a mathematical expression below,

$$\theta_1 > 90° - \theta_{c1}$$

wherein the letter $\theta_{c1}$ denotes an angle at which a portion of light emitted by the organic light emitting layer (116) is totally reflected at an interface between one of the pixel electrodes (114) and the overcoat layer (113).

12. The display apparatus of claim 10 or 11, wherein

the $\theta_{c1}$ is provided to satisfy a mathematical expression below,

$$\theta_{c1} = \arcsin\left(\frac{n_{oc}}{n_{Anode}}\right)$$

wherein the letter $n_{oc}$ denotes a refractive index of the overcoat layer (113), and the letter $n_{Anode}$ denotes a refractive index of the pixel electrodes (114); and/or
wherein the first angle $\theta_1$ is provided to satisfy a mathematical expression below,

$$\theta_1 < 135° - 0.5\arcsin\left(\frac{n_{oc}}{n_{Anode}}\right) - 0.5\arcsin\left(\frac{n_{oc}}{n_{Anode}}\sin\left(\arcsin\left(\frac{1}{n_{oc}}\right)\right)\right)$$

wherein the letter $n_{oc}$ denotes a refractive index of the overcoat layer (113), and the letter $n_{Anode}$ denotes a refractive index of the pixel electrodes (114); and/or
wherein the second angle $\theta_2$ is provided to satisfy a mathematical expression below,

$$\theta_2 < \arcsin\left(\frac{n_{air}}{n_{oc}}\right)$$

wherein the letter $n_{oc}$ denotes a refractive index of the overcoat layer (113), and the letter $n_{air}$ denotes the refractive index of air.

13. The display apparatus according to any one of the preceding claims, wherein the pattern portion (120) further comprises:

a third inclined pattern portion (120s3) disposed closer to the substrate (110) than the second inclined pattern portion (120s2) and having a third angle ($\theta_2$) with respect to the substrate (110); and
a third flat pattern portion (120b3) extending from the third inclined pattern portion (120s3).

14. The display apparatus according to any one of the preceding claims, wherein the first angle and the second angle are different, and
wherein the first inclined pattern portion (120s1) is directly connected to the second inclined pattern portion (120s2) at a connection point.

15. The display apparatus of claim 14, wherein the connection point is disposed in the non-light emission area (NEA).

# FIG. 1

# FIG. 2

# FIG. 3

I-I'

SP(SP3)

EA | NEA(SP2) | NEA | EA | NEA | NEA(SP4) | EA

130(117a)

134 133 132 131    A    117 116 114

E

120(122)

120s { 120s1
(122s) 120s2

120b { 120b1
(122b) 120b2

200
118

D1
EXL1
D2  D_T
θ₂  θ₁  113a
EXL2

120s1
120s2  } 120s (122s)

120b1
120b2  } 120b (122b)

113
CF2
111c } 111
111b
BL
110

RL    EL2    EL1  CF1  110a    DL3    DL4

EL    CF    DL

Z
X ← ⊙ Y

EP 4 601 441 A1

# FIG. 4

SP(SP3)

NEA | EA | NEA | EA

E

130(117a)

115

117 116 114

131 132 133 134

113a

200

118

113

111c ⎱ 111
111b ⎰
BL
110

EVDD

CF1

120s1 120b1 RL 120s2 120b2

CF

120 → 120s(121s)

120b(121b)

EP 4 601 441 A1

# FIG. 5

EP 4 601 441 A1

# FIG. 6

EP 4 601 441 A1

## FIG. 7

# FIG. 8A

# FIG. 8B

# FIG. 8C

# FIG. 9

# FIG. 10

EP 4 601 441 A1

Europäisches
Patentamt
European
Patent Office
Office européen
des brevets

**Application Number**

EP 24 20 6980

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/413634 A1 (LEE YOUNGWOOK [KR] ET AL) 21 December 2023 (2023-12-21) * claims 1-23; figures 2, 3 * | 1-15 | INV. H10K59/122 H10K59/80 |

TECHNICAL FIELDS
SEARCHED      (IPC)

H10K

The present search report has been drawn up for all claims

| Place of search | Date of completion of the search | Examiner |
|---|---|---|
| The Hague | 17 March 2025 | Parashkov, Radoslav |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

                                                                    
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 20 6980

This annex lists the patent family members relating to the patent documents cited in the above-mentioned European search report.
The members are as contained in the European Patent Office EDP file on
The European Patent Office is in no way liable for these particulars which are merely given for the purpose of information.

17-03-2025

| Patent document cited in search report | Publication date | Patent family member(s) | Publication date |
|---|---|---|---|
| US 2023413634 A1 | 21-12-2023 | CN 117279432 A | 22-12-2023 |
| | | KR 20230173983 A | 27-12-2023 |
| | | US 2023413634 A1 | 21-12-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240018330